# EUROPEAN PATENT APPLICATION

(11) **EP 3 492 509 A1**
(43) Date of publication of application: **05.06.2019**
(21) Application number: 19151363.9
(22) Date of filing: 12.02.2015
(51) Int. Cl.: C08G 61/12, C09D 11/00, H01L 51/50

(54) **POLYMER OR OLIGOMER, HOLE TRANSPORT MATERIAL COMPOSITION, AND ORGANIC ELECTRONIC ELEMENT USING SAME**

(30) Priority: 14.02.2014 JP 2014026554
(62) Divisional of application: 15749670.4
(71) Applicant: Hitachi Chemical Company, Ltd., Chiyoda-ku Tokyo 100-6606 (JP)
(72) Inventor: Funyuu, Shigeaki, Tokyo, 100-6606 (JP); Fukushima, Iori, Tokyo, 100-6606 (JP); Ishitsuka, Kenichi, Tokyo, 100-6606 (JP); Asano, Naoki, Tokyo, 100-6606 (JP); Ryuzaki, Daisuke, Tokyo, 100-6606 (JP)
(74) Representative: Hoffmann Eitle

(57) **Abstract**

An embodiment of the present invention relates to a polymer or oligomer (A) containing a structural unit with hole transport properties, and also containing at least one type of organic group selected from the group consisting of groups having an ester linkage, groups having a carbonyl linkage, groups having an amide linkage, and groups having an imide linkage

## Description

### Technical Field

One embodiment of the present invention relates to a polymer or an oligomer. Other embodiments of the present invention relate to a composition, a hole transport material composition and an ink composition which contain the polymer or oligomer. Yet other embodiments of the present invention relate to an organic electronic element, an organic electroluminescent element (also referred to as an "organic EL element"), and an organic photoelectric conversion element and the like, formed using the above-mentioned composition, hole transport material composition or ink composition.

### Background Art

Organic electronic elements are elements which use an organic substance to perform an electrical operation. It is expected that organic electronic elements will be capable of providing advantages such as lower energy consumption, lower prices and greater flexibility, and they are therefore attracting considerable attention as a potential alternative technology to conventional inorganic semiconductors containing mainly silicon.

Among organic electronic elements, organic EL elements are attracting attention for potential use in large-surface area solid state lighting applications to replace incandescent lamps or gas-filled lamps. Further, they are also attracting attention as the leading self-luminous display for replacing liquid crystal displays (LCD) in the field of flat panel displays (FPD), and commercial products are becoming increasingly available.

In organic EL elements, multilayering of the organic layers that constitute the element is used to improve certain element properties such as the light emission efficiency and the element lifespan (for example, see Patent Literature 1 and Patent Literature 2 and the like). However, some properties of organic EL elements are still not entirely satisfactory for use within the types of applications mentioned above, and further improvements in the element properties are still being sought.

On the other hand, in recent years, the size of organic EL elements has continued to increase, and in order to form the organic layers with greater efficiency, methods in which an ink composition containing the organic substance is applied using a wet process such as an inkjet method are being investigated.

Application by a representative inkjet method is performed in the following manner. First, partition walls having openings that correspond with the size of individual pixels are provided on a substrate. Next, the ink head is scanned relatively across the substrate on which the partition walls have been provided, and an ink composition is dripped into the openings from nozzles on the ink head. Subsequently, the solvent is evaporated from the dripped ink composition to form an organic layer within the openings (for example, see Patent Literature 3).

### Citation List

### Patent Literature

PLT 1: JP 2,597,377 B
PLT 2: JP 3,529,543 B
PLT 3: JP 2013-240733 A

### Summary of Invention

### Technical Problem

When an organic EL element is formed using an inkjet method, sometimes the ink composition may not spread across the entire area inside the opening in which the organic layer is to be provided. Any region within an opening across which the ink composition does not spread becomes a defect, and is one reason that can prevent a satisfactory lifespan from being obtained.

In light of the above circumstances, embodiments of the present invention have objects of providing a polymer or oligomer, a composition, a hole transport material composition and an ink composition that are useful for improving the lifespan of organic electronic elements. Further, another embodiment of the present invention has an object of providing an organic layer that is useful for improving the lifespan of an organic electronic element. Moreover, yet other embodiments of the present invention have objects of providing an organic electronic element, an organic EL element, an organic photoelectric conversion element, a display element, an illumination device and a display device which exhibit excellent lifespan properties.

### Solution to Problem

As a result of intensive investigations, the inventors of the present invention discovered that by using a polymer or oligomer having a structural unit with hole transport properties, and also having at least one type of organic group selected from the group consisting of groups having an ester linkage, groups having a carbonyl linkage, groups having an amide linkage, and groups having an imide linkage, the lifespan of an organic electronic element could be improved, and they were therefore able to complete the present invention.

In other words, one embodiment of the present invention relates to a polymer or oligomer (A) comprising a structural unit with hole transport properties, and also comprising at least one type of organic group selected from the group consisting of groups having an ester linkage, groups having a carbonyl linkage, groups having an amide linkage, and groups having an imide linkage.

In one embodiment, the structural unit with hole transport properties preferably comprises at least one type of structural unit selected from the group consisting of units having an aromatic amine structure, units having a carbazole structure, and units having a thiophene structure.

In one embodiment, the polymer or oligomer (A) may also comprise a substituent having a polymerizable group.

In one embodiment, the polymer or oligomer (A) may have a branched structure, and have three or more terminals.

In one embodiment, the organic group preferably comprises at least one type of organic group selected from the group consisting of organic groups (al-1) to (al-9) shown below.

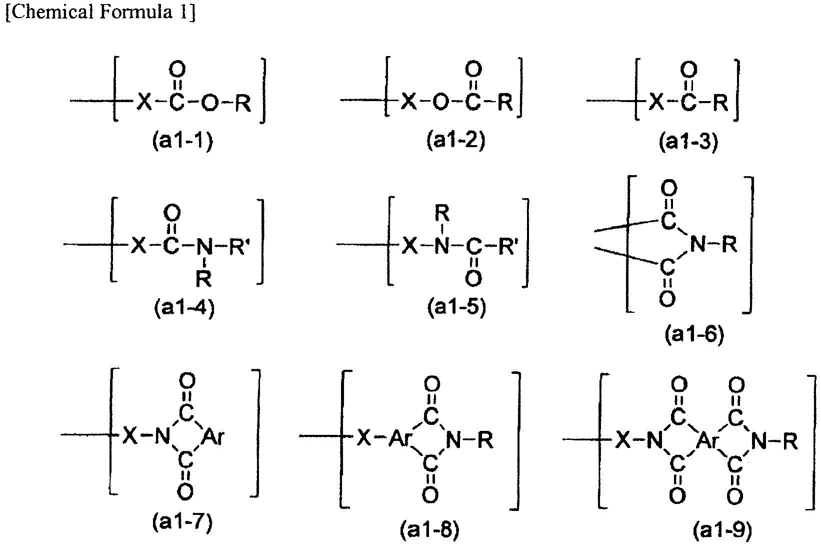

In the formulas, each R and R' independently represents a hydrogen atom, a linear, cyclic or branched alkyl group having a carbon number of 1 to 22, or an aryl group or heteroaryl group having a carbon number of 2 to 30,
X represents a single bond, a linear, cyclic or branched alkylene group having a carbon number of 1 to 22, or an arylene group or heteroarylene group having a carbon number of 2 to 30, and
Ar represents an arylene group or heteroarylene group having a carbon number of 2 to 30, an arene-triyl group or heteroarene-triyl group having a carbon number of 2 to 30, or an arene-tetrayl group or heteroarene-tetrayl group having a carbon number of 2 to 30.

In one embodiment, the weight-average molecular weight of the polymer or oligomer (A) is preferably within a range from 1,000 to 1,000,000.

Further, another embodiment of the present invention relates to a composition comprising the polymer or oligomer (A) and a solvent (B).

In one embodiment, the composition may also comprise an ionic compound (C).

Further, yet another embodiment of the present invention relates to a hole transport material composition or an ink composition comprising the composition described above.

Further, yet another embodiment of the present invention relates to an organic layer formed using the composition described above, the hole transport material composition described above, or the ink composition described above.

Furthermore, yet another embodiment of the present invention relates to an organic electronic element having at least two electrodes, and the organic layer described above positioned between the electrodes; an organic electroluminescent element having an anode, the organic layer described above, a light-emitting layer and a cathode; or an organic photoelectric conversion element having an anode, the organic layer described above, a photoelectric conversion layer and a cathode.

Moreover, yet another embodiment of the present invention relates to a display element or illumination device comprising the organic electroluminescent element described above; or a display device comprising the illumination device, and a liquid crystal element as a display unit.

The present invention is related to the subject matter disclosed in Japanese Application 2014-026554 filed on February 14, 2014, the entire contents of which are incorporated by reference herein.

### Advantageous Effects of Invention

Embodiments of the present invention are able to provide a polymer or oligomer, a composition, a hole transport material composition and an ink composition that are useful for improving the lifespan of organic electronic elements. Another embodiment of the present invention is able to provide an organic layer that is useful for improving the lifespan of an organic electronic element. Moreover, yet other embodiments of the present invention are able to provide an organic electronic element, an organic EL element, an organic photoelectric conversion element, a display element, an illumination device and a display device which exhibit excellent lifespan properties.

### Brief Description of Drawings

FIG. 1 is a schematic cross-sectional view illustrating one example of an organic EL element that represents one embodiment of the present invention.
FIG. 2 is a schematic cross-sectional view illustrating one example of an organic EL element that represents one embodiment of the present invention.

### Description of Embodiments

Embodiments of the present invention are described below in detail.

### [Polymer or Oligomer (A)]

The polymer or oligomer (A) that represents one embodiment of the present invention has a structural unit with hole transport properties, and also has at least one type of organic group (also referred to as "the organic group (a)") selected from the group consisting of groups having an ester linkage, groups having a carbonyl linkage, groups having an amide linkage, and groups having an imide linkage. The organic group (a) includes monovalent or divalent substituents (also referred to as "the organic group (a1)"), and divalent linking groups (also referred to as "the organic group (a2)"). The polymer or oligomer (A) may also have a substituent having a polymerizable group (also referred to as "the polymerizable substituent (b)"). Further, the polymer or oligomer (A) may have a branched structure within the molecule, and have three or more terminals.

### [Structural Unit with Hole Transport Properties]

There are no particular limitations on the structural unit with hole transport properties, provided that the structural unit includes an atom grouping that has the ability to transport an electric charge. In terms of having superior hole transport properties, the structural unit with hole transport properties preferably includes, as the atom grouping, an aromatic amine structure (namely, an amine structure having an aromatic ring), a carbazole structure, or a thiophene structure. The aromatic amine is preferably a triarylamine, and more preferably a triphenylamine.

The polymer or oligomer (A) may have, as the structural unit with hole transport properties, either a single type of unit, or two or more types of units, selected from the group consisting of units having an aromatic amine structure, units having a carbazole structure, and units having a thiophene structure. The polymer or oligomer (A) preferably has a unit having an aromatic amine structure and/or a unit having a carbazole structure.

Specific examples of the structural unit with hole transport properties include the structural units (1a) to (84a) shown below.

### <Structural Units (1a) to (84a)>

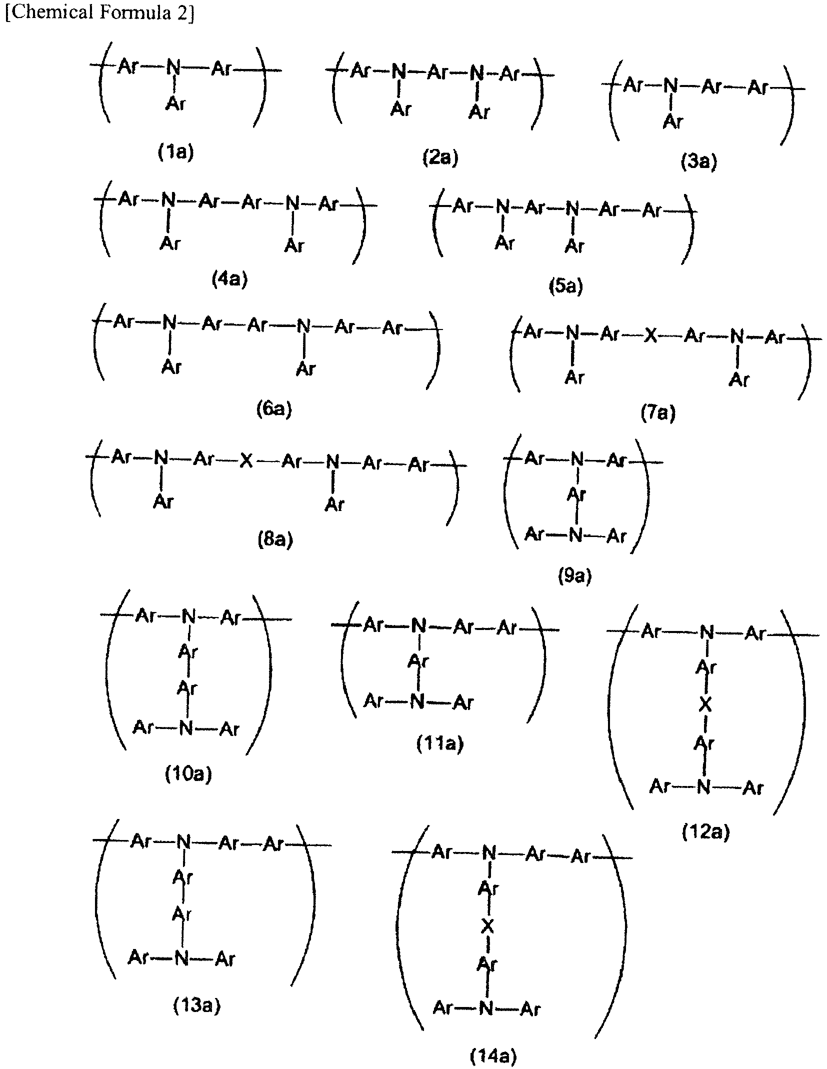

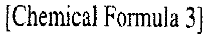

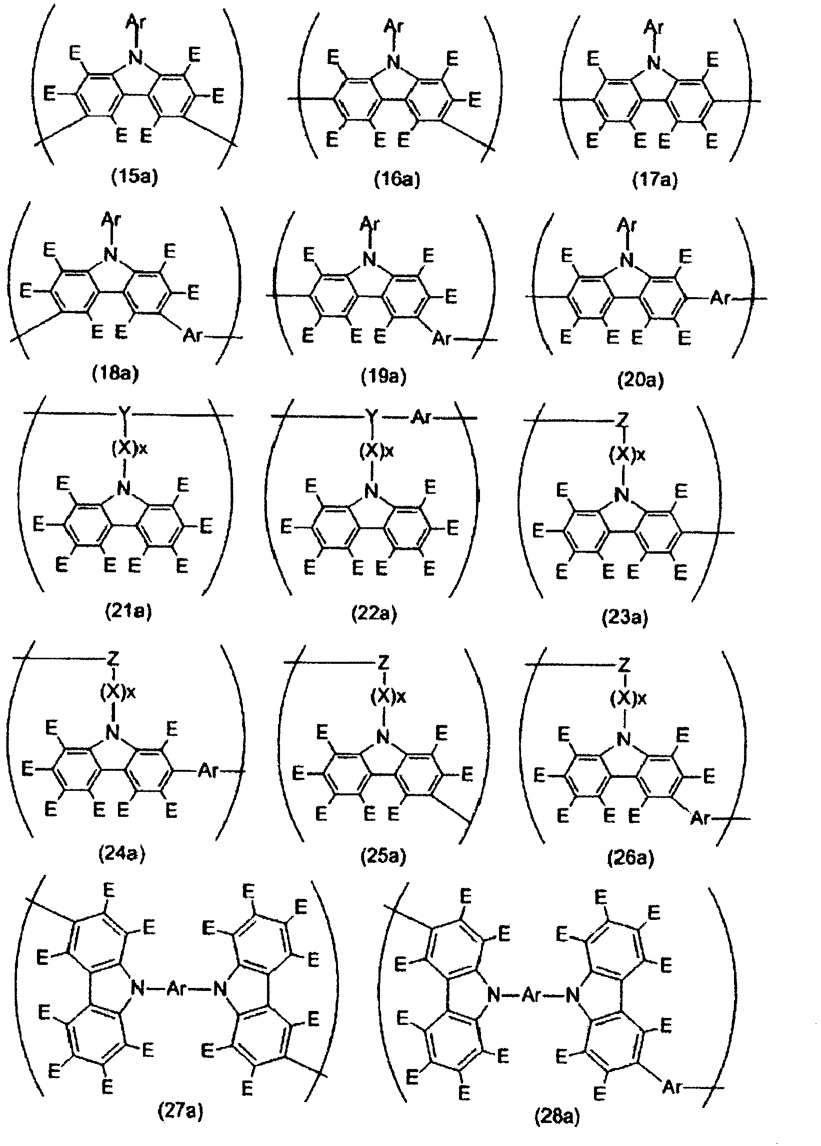

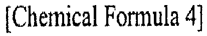

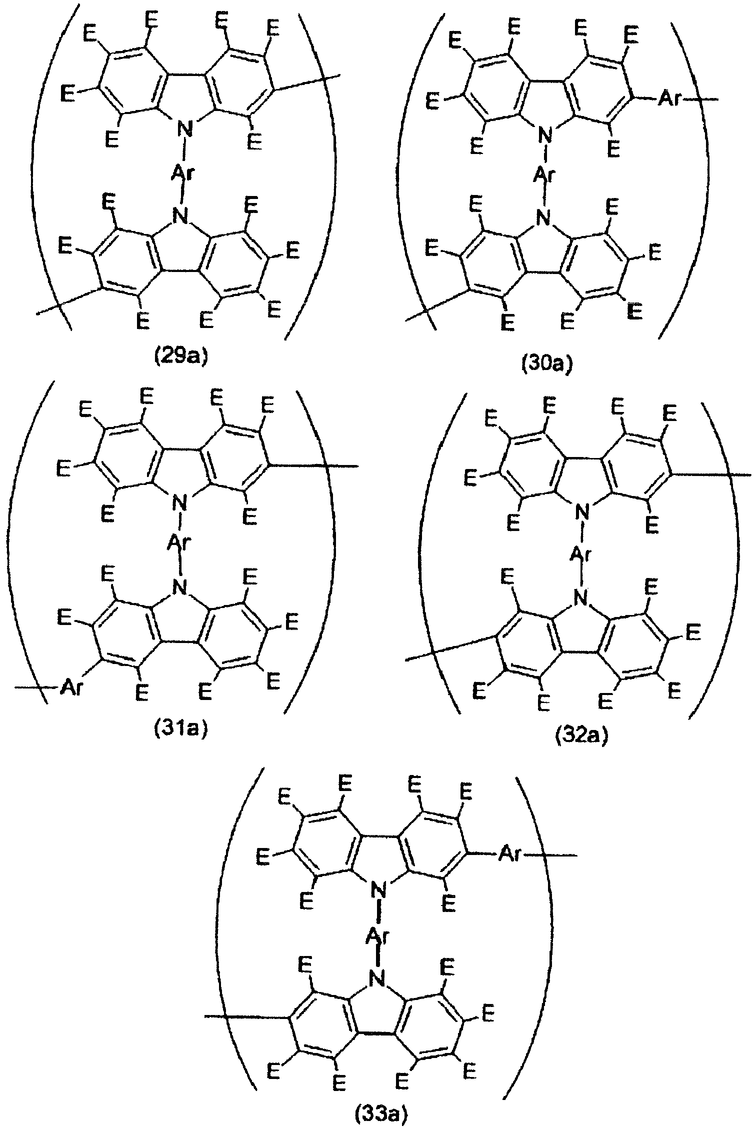

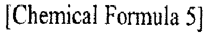

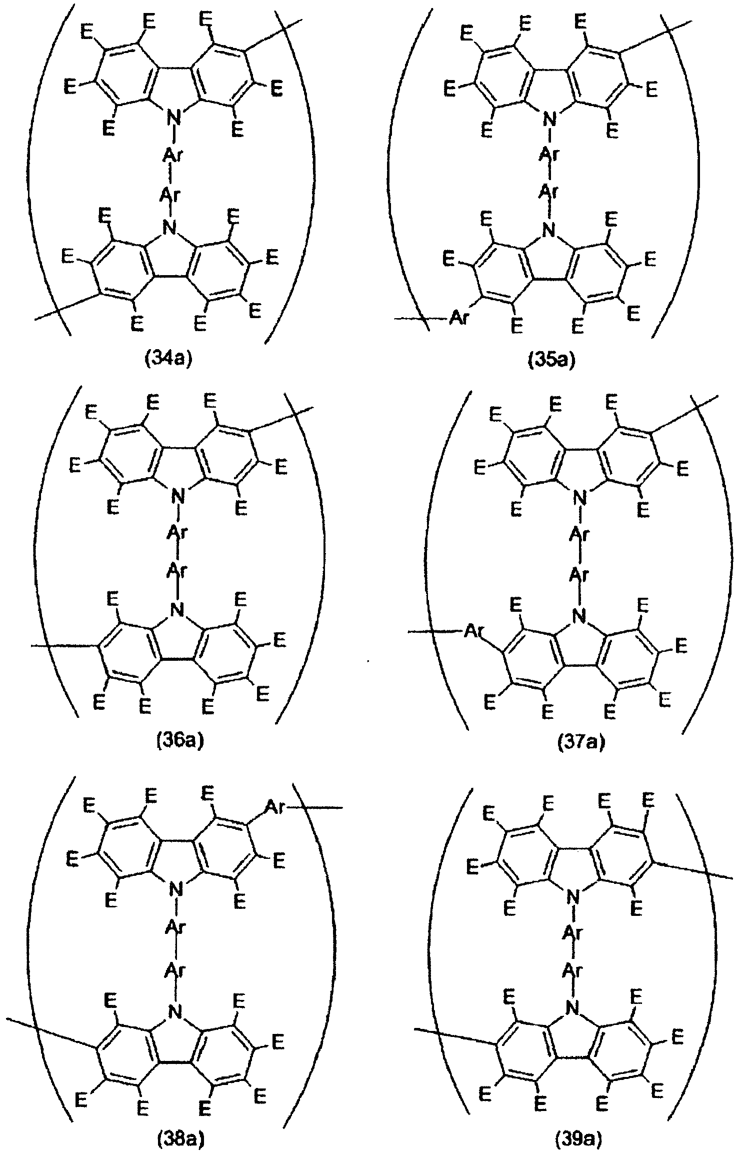

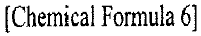

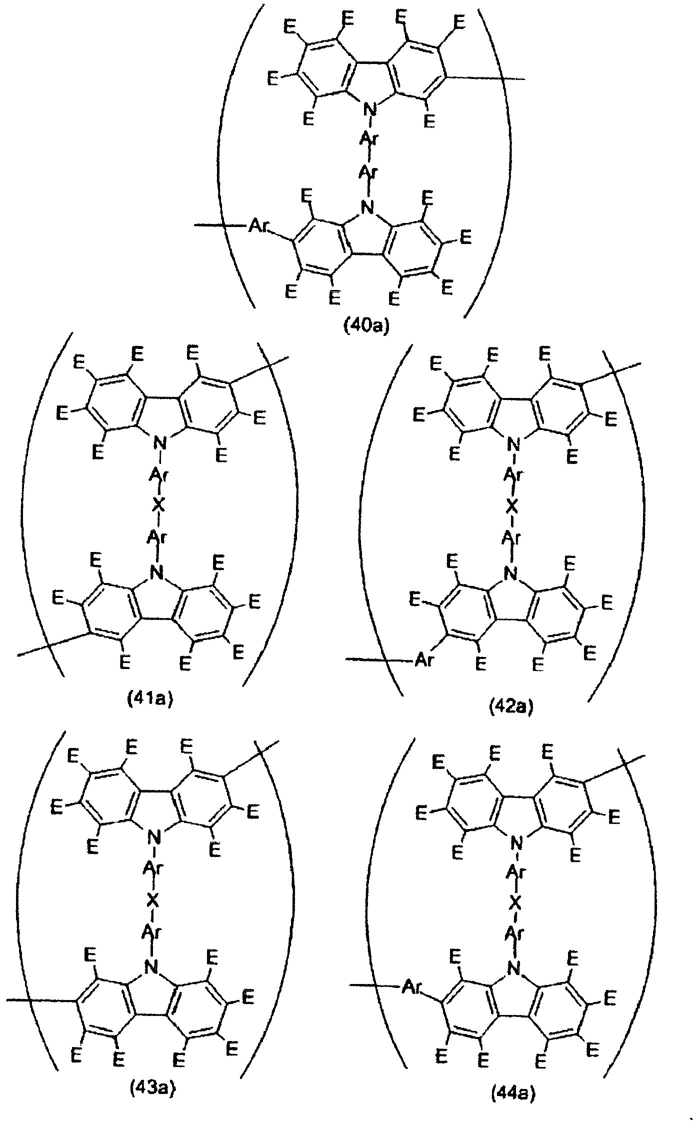

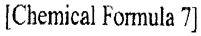

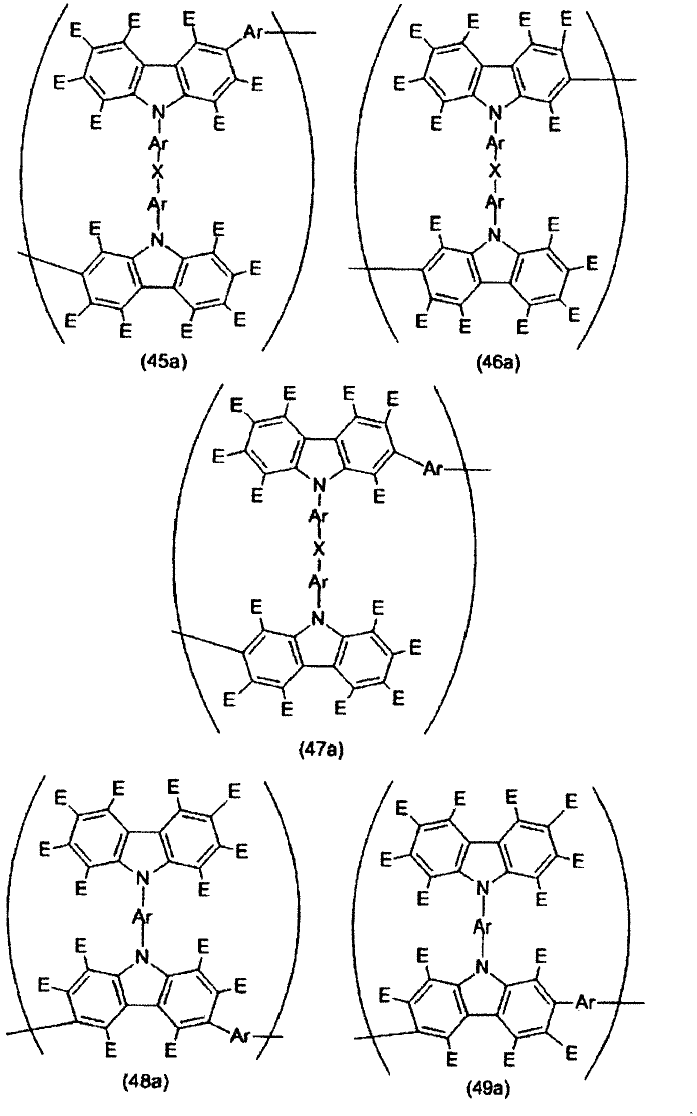

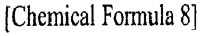

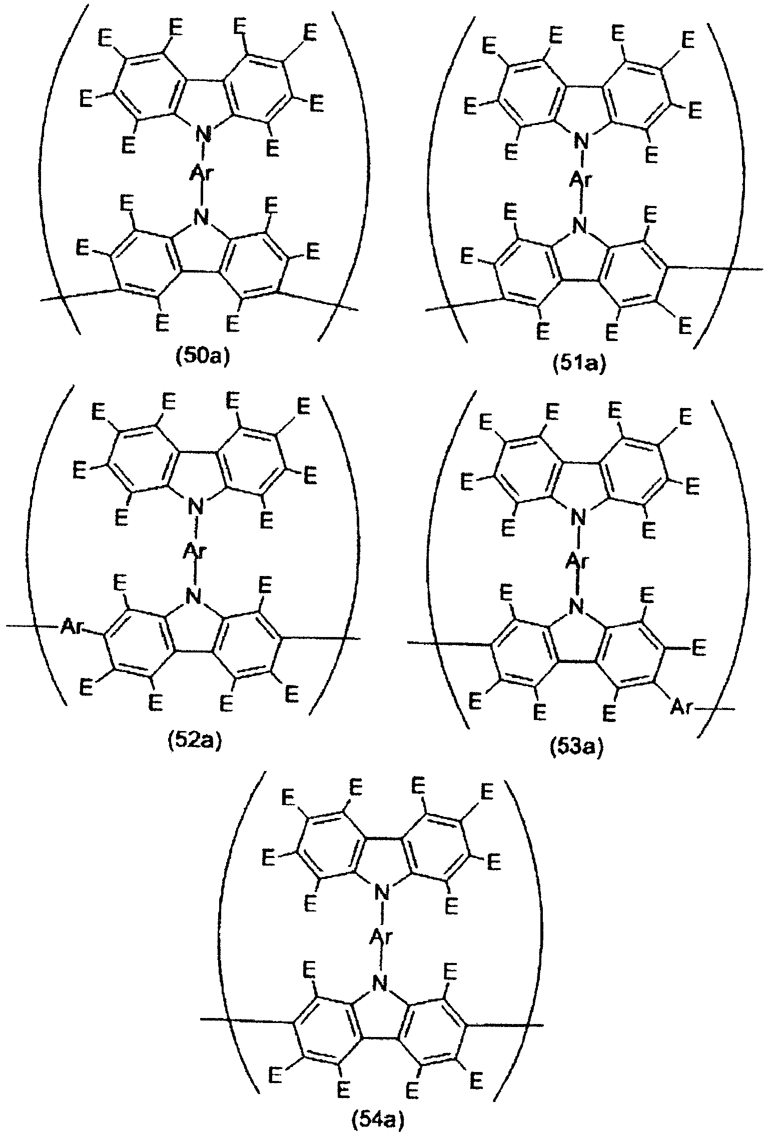

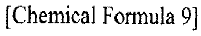

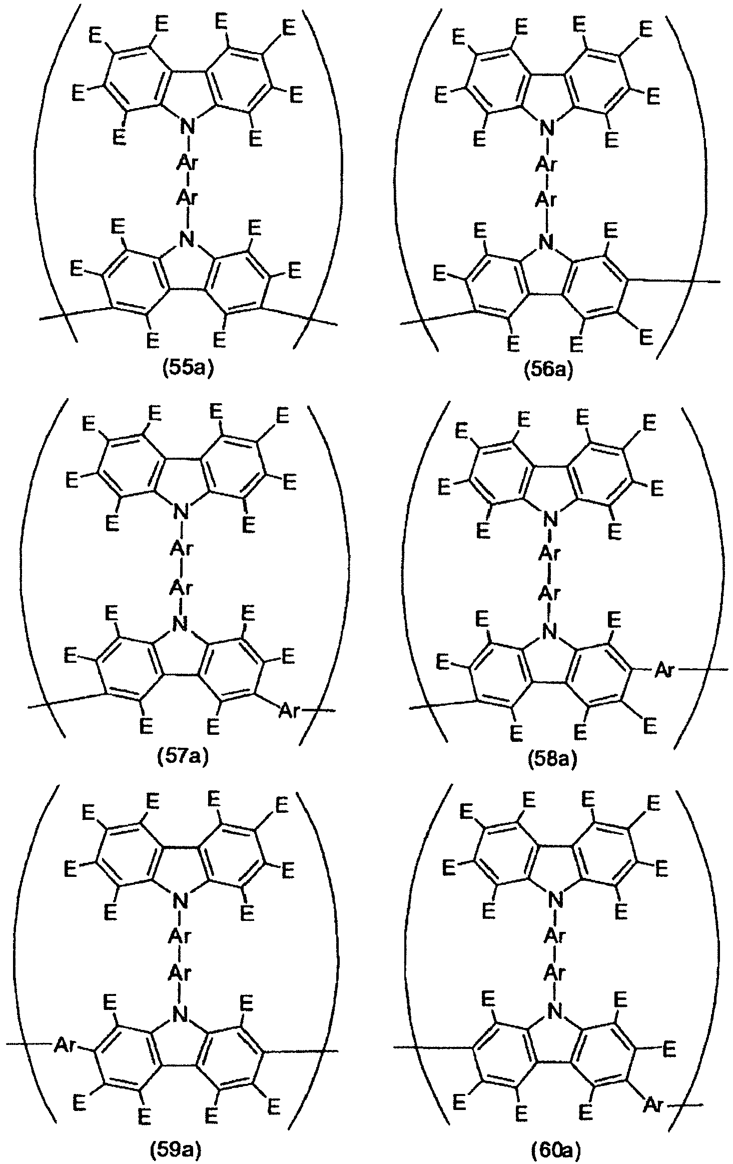

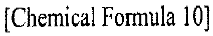

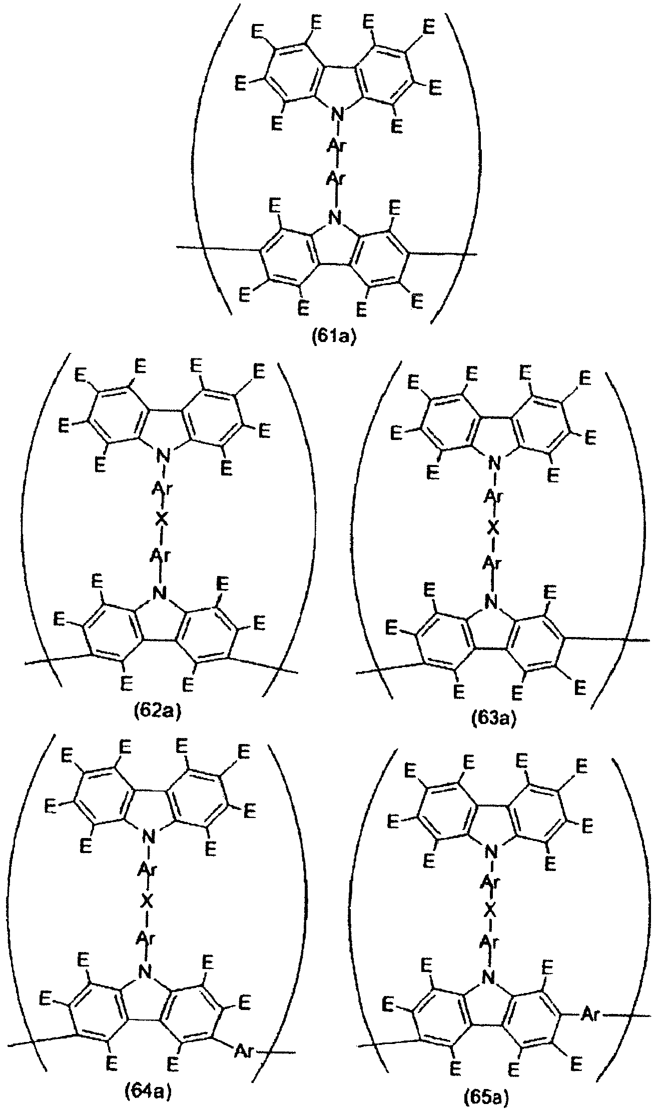

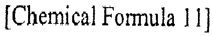

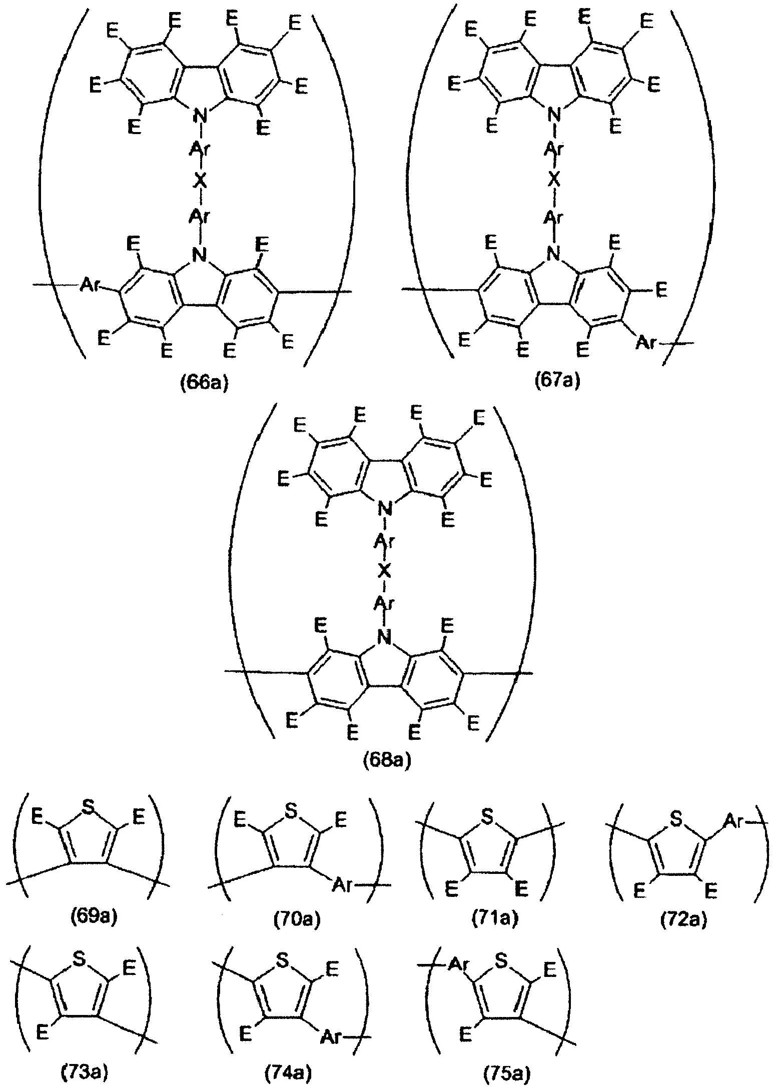

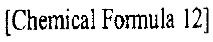

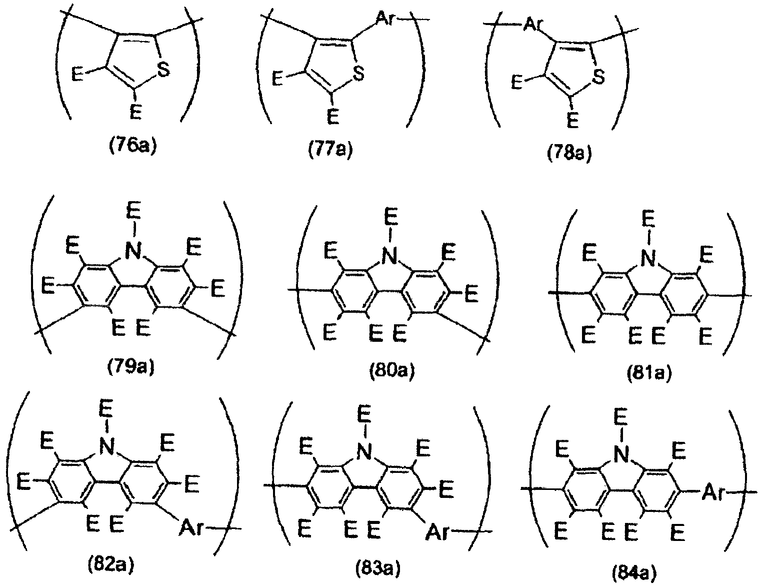

In the above formulas, each E independently represents a group selected from the group consisting of-R¹, -OR², -SR³, -SiR⁴R⁵R⁶, formulas (a) to (c) shown below, the organic group (a1), and the polymerizable substituent (b).

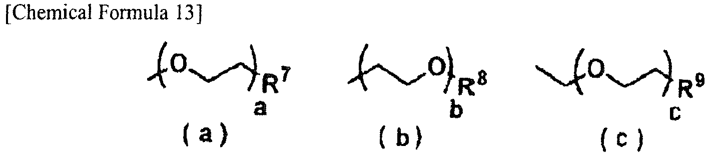

Each of R¹ to R⁹ independently represents a hydrogen atom, a linear, cyclic or branched alkyl group having a carbon number of 1 to 22, or an aryl group or heteroaryl group having a carbon number of 2 to 30.

Each of R¹ to R⁹ may have a substituent, and examples of the substituent include an alkyl group, alkoxy group, alkylthio group, aryl group, aryloxy group, arylthio group, arylalkyl group, arylalkoxy group, arylalkylthio group, arylalkenyl group, arylalkynyl group, hydroxyl group, hydroxyalkyl group, amino group, substituted amino group, silyl group, substituted silyl group, silyloxy group, substituted silyloxy group, halogen atom, imino group, cyano group, heteroaryl group, and the organic group (a1).

Each of a, b and c represents an integer of 1 or greater, and is preferably an integer of 1 to 4.

The organic group (a1) and the polymerizable substituent (b) are described below in further detail.

In the formulas, each Ar independently represents an aryl group or heteroaryl group having a carbon number of 2 to 30, or an arylene group or heteroarylene group having a carbon number of 2 to 30.

Each Ar may have a substituent, and examples of the substituent include the same groups as those described above for E.

In the formulas, each X and Z independently represents a divalent linking group, and there are no other particular limitations on the group. Examples include groups in which one additional hydrogen atom has been removed from an aforementioned E group having one or more hydrogen atoms (but excluding the polymerizable substituent (b)); groups described in the linking group set (A) described below; and the organic group (a2). The organic group (a2) is described below in further detail.

Further, x represents an integer of 0 to 2.

Y represents a trivalent linking group, and there are no other particular limitations. Examples include groups in which two additional hydrogen atoms have been removed from an aforementioned E group having two or more hydrogen atoms (but excluding the polymerizable substituent (b)).

### <Linking Group Set (A)>

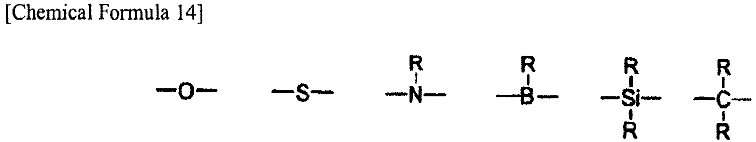

In the above formulas, each R independently represents a hydrogen atom; a linear, cyclic or branched alkyl group having a carbon number of 1 to 22 which may have a substituent; or an aryl group or heteroaryl group having a carbon number of 2 to 30 which may have a substituent.

In the present embodiment, examples of the alkyl group include a methyl group, ethyl group, n-propyl group, n-butyl group, n-pentyl group, n-hexyl group, n-heptyl group, n-octyl group, n-nonyl group, n-decyl group, n-undecyl group, n-dodecyl group, isopropyl group, isobutyl group, sec-butyl group, tert-butyl group, 2-ethylhexyl group, 3,7-dimethyloctyl group, cyclohexyl group, cycloheptyl group and cyclooctyl group.

In the present embodiment, the aryl group is an atom grouping in which one hydrogen atom has been removed from an aromatic hydrocarbon, whereas a heteroaryl group is an atom grouping in which one hydrogen atom has been removed from an aromatic compound having a hetero atom.

Examples of the aryl group include phenyl, biphenylyl, terphenylyl, naphthalenyl, anthracenyl, tetracenyl, fluorenyl and phenanthrenyl groups.

Examples of the heteroaryl group include pyridinyl, pyrazinyl, quinolinyl, isoquinolinyl, acridinyl, phenanthrolinyl, furanyl, pyrrolyl, thiophenyl, carbazolyl, oxazolyl, oxadiazolyl, thiadiazolyl, triazolyl, benzoxazolyl, benzoxadiazolyl, benzothiadiazolyl, benzotriazolyl and benzothiophenyl groups.

These groups can also be used as examples of the alkyl groups, aryl groups and heteroaryl groups mentioned in the following description.

In the present embodiment, an arylene group is an atom grouping in which two hydrogen atoms have been removed from an aromatic hydrocarbon, whereas a heteroarylene group is an atom grouping in which two hydrogen atoms have been removed from an aromatic compound having a hetero atom.

Examples of the arylene group include phenylene, biphenyl-diyl, terphenyl-diyl, naphthalene-diyl, anthracene-diyl, tetracene-diyl, fluorene-diyl and phenanthrene-diyl groups.

Examples of the heteroarylene groups include pyridine-diyl, pyrazine-diyl, quinoline-diyl, isoquinoline-diyl, acridine-diyl, phenanthroline-diyl, furan-diyl, pyrrole-diyl, thiophene-diyl, carbazole-diyl, oxazole-diyl, oxadiazole-diyl, thiadiazole-diyl, triazole-diyl, benzoxazole-diyl, benzoxadiazole-diyl, benzothiadiazole-diyl, benzotriazole-diyl and benzothiophene-diyl groups.

These groups can also be used as examples of the arylene groups and heteroarylene groups mentioned in the following description.

### [Branched Structure]

The polymer or oligomer (A) may have a branched structure within the molecule, and have three or more terminals. A branched structure describes a structure in which the polymer or oligomer chain has a branched portion, with the structural units that constitute the chain of the polymer or oligomer extending in three or more directions from the branched portion. The polymer or oligomer (A) has, for example, a structural unit that becomes the branch origin (hereafter also referred to as a "branch origin structural unit") as the branch portion. A polymer or oligomer (A) having a branched structure and having three or more terminals contains a main chain and a side chain. The polymer or oligomer (A) may have only one type of branch origin structural unit, or may have two or more types.

Specific examples of branch origin structural units include the structural units (1b) to (11b) shown below.

### <Structural Units (1b) to (11b)>

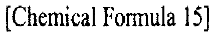

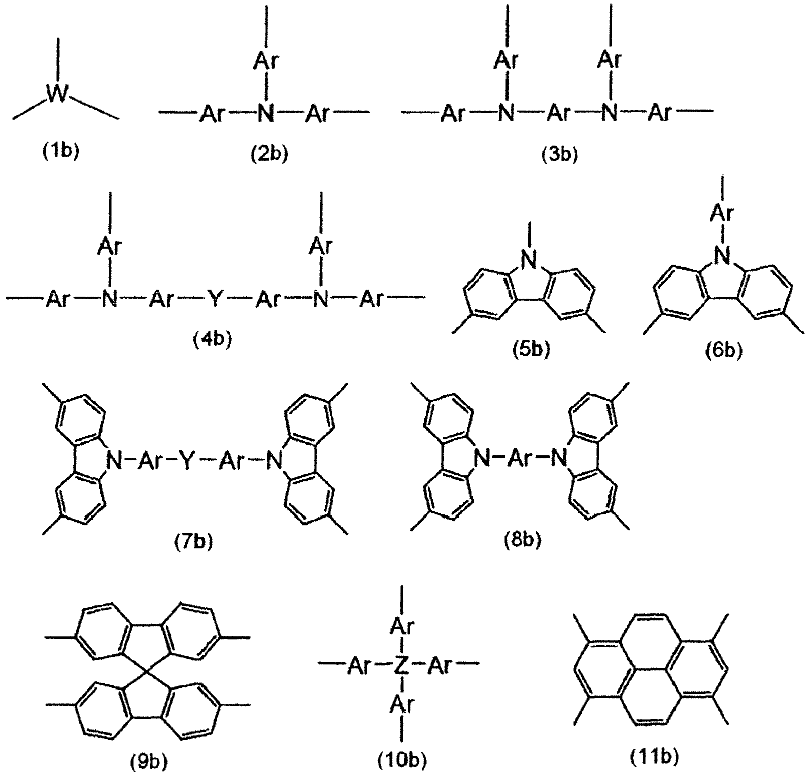

In the above formulas, W represents a trivalent linking group, and examples include groups in which one additional hydrogen atom has been removed from an arylene group or heteroarylene group having a carbon number of 2 to 30.

Each Ar independently represents a divalent linking group, and for example, represents an arylene group or heteroarylene group having a carbon number of 2 to 30. Each Ar is preferably an arylene group, and more preferably a phenylene group.

Y represents a divalent linking group, and there are no other particular limitations on the group. Examples include groups in which one additional hydrogen atom has been removed from an aforementioned E group having one or more hydrogen atoms (but excluding the polymerizable substituent (b)); groups described in the linking group set (A) mentioned above; and the organic group (a2).

Z represents a carbon atom, silicon atom or phosphorus atom.

The structural units (1b) to (11b) may have a substituent, and examples of the substituent include the same groups as those described above for E.

### [Copolymer Unit]

The polymer or oligomer (A) may also include another copolymer unit besides the units described above, for the purpose of adjusting the electrical properties or introducing the organic group (a1) and/or the polymerizable substituent (b). Examples of this other copolymer unit include the arylene groups and heteroarylene groups described above, and the structural units (1) to (28) shown below. The polymer or oligomer (A) may include only one type of this other copolymer unit, or may include two or more types.

### <Structural Units (1) to (28)>

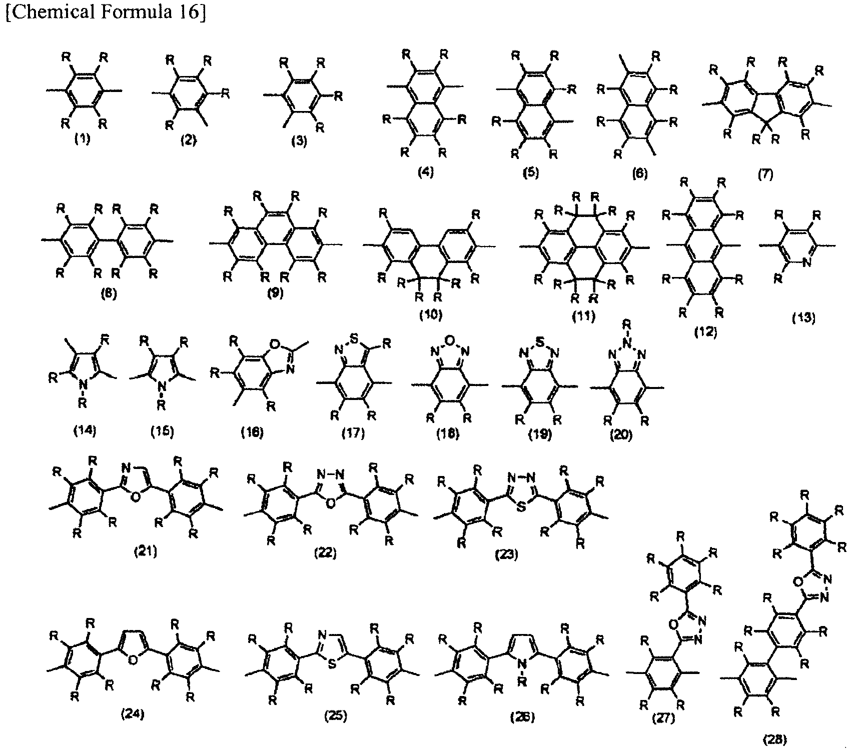

Examples of R include the same groups as those described above for E.

### [Terminal Structures]

There are no particular limitations on the structural units at the terminals of the polymer or oligomer (A). Examples of the terminal structural unit include the structural units (1a) to (84a) mentioned above, as well as structural units having an aromatic hydrocarbon structure or an aromatic compound structure. Examples of the structural units having an aromatic hydrocarbon structure or an aromatic compound structure include structural units (1c) represented by the formula shown below. The polymer or oligomer (A) may have only one type of terminal structural unit, or may have two or more types.

### <Structural Unit (1c)>

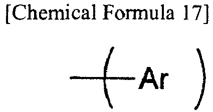

Ar represents an aryl group or heteroaryl group having a carbon number of 2 to 30. Ar may have a substituent, and examples of the substituent include the same groups as those described above for E.

### [Organic Group (a)]

The polymer or oligomer (A) has at least one type of the organic group (a) selected from the group consisting of groups having an ester linkage, groups having a carbonyl linkage (but excluding groups corresponding with the "groups having an ester linkage", "groups having an amide linkage" and "groups having an imide linkage"), groups having an amide linkage, and groups having an imide linkage. The organic group (a) is either a monovalent or divalent substituent (the organic group (a1)), or a divalent linking group (the organic group (a2)), and is preferably a monovalent or divalent substituent. For example, the organic group (a1) may be a group that can be introduced in place of one or two hydrogen atoms, whereas the organic group (a2) is a group that can be introduced in place of a single bond. In one embodiment, the organic group (a) may be a group that is different from a polymerizable group described below, and also different from the polymerizable substituent (b).

Further, in another embodiment, the organic group (a) may be a group that contains a polymerizable group. In other words, the organic group (a) may be selected from among the polymerizable groups described below, or selected from among the polymerizable substituents (b).

By using the polymer or oligomer (A) containing the organic group (a), an organic electronic element having excellent lifespan properties can be obtained. It is assumed that one reason for this is as follows. However, the present invention is not limited to the following reasoning. The organic group (a) has a polarized structure. Consequently, for example, when another organic layer (upper layer) is stacked on top of the organic layer (lower layer) formed using the polymer or oligomer (A), large intermolecular interactions are obtained between the polymer or oligomer (A) and the organic material used in forming the upper layer. As a result, the film-forming properties of the upper layer improve, and excellent lifespan properties can be obtained. Furthermore, when a coating solution (namely, a composition containing the organic material and a solvent) is used for forming the upper layer on the organic layer formed using the polymer or oligomer (A), the wettability of the organic layer by the coating solution improves, enabling an upper layer of excellent uniformity to be obtained. Moreover, by using the organic group (a), the film-forming properties and the hole transport properties of the organic layer formed using the polymer or oligomer (A) are also improved.

There are no particular limitations on the position of the organic group (a) within the polymer or oligomer (A). The polymer or oligomer (A) may contain the organic group (a) within a terminal structural unit, within a non-terminal structural unit, or within both a terminal structural unit and a non-terminal structural unit.

From the viewpoint of ease of synthesis of the polymer or oligomer (A), and from the viewpoint of facilitating the ease with which the polymer or oligomer (A) can be imparted with the desired functionality, the polymer or oligomer (A) preferably contains the organic group (a) within a terminal structural unit. In particular, by introducing an organic group (a) having a polymerizable group within the structure into a terminal structural unit, the lifespan properties can be improved and favorable curability can be achieved with good efficiency, while maintaining excellent hole transport properties.

In terms of improving the lifespan of organic electronic elements, the number of organic groups (a) per single molecule of the polymer or oligomer (A) is preferably at least 1, more preferably 2 or greater, and even more preferably 3 or greater. Further, from the viewpoint of the solubility of the polymer or oligomer (A), the number of organic groups (a) is preferably not more than 1,000, more preferably 500 or fewer, and even more preferably 200 or fewer.

Specific examples of the organic group (a1) and the organic group (a2) are shown below.

### <Organic Groups (a1-1) to (a1-9)>

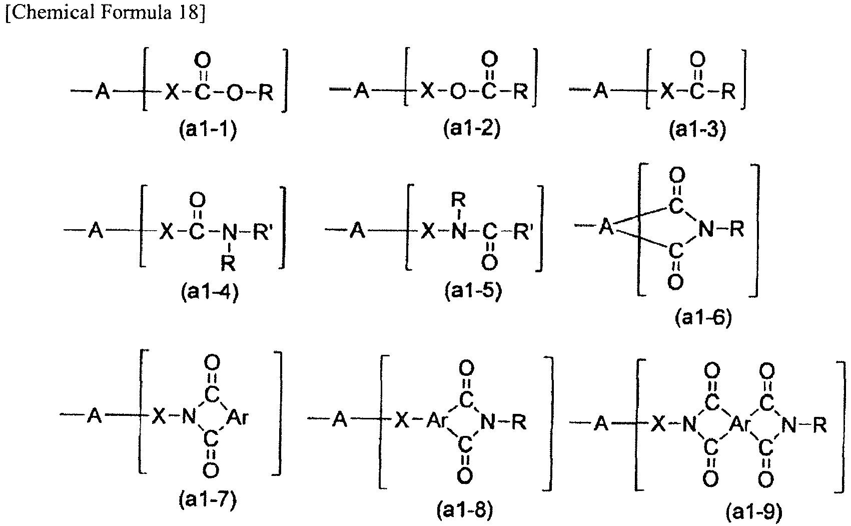

In each of the above formulas, the portion inside the square brackets represents a specific example of the organic group (a1).

A represents a part or all of the structural units incorporated in the polymer or oligomer (A), and is included in the above formulas for the purpose of explaining the organic group (a1). A represents, for example, a group in which an additional one or two hydrogen atoms have been removed from an aryl group or heteroaryl group having a carbon number of 2 to 30, and is contained in a structural unit that constitutes the polymer or oligomer (A). However, the bonding position of the organic group (a1) is not specifically limited to the above. The expression "aryl group or heteroaryl group having a carbon number of 2 to 30" refers, for example, to the "-Ar" group in the structural unit (1a) or the "-Ar" group in the structural unit (1c) or the like.

In the formulas, each R and R' independently represents a hydrogen atom, a linear, cyclic or branched alkyl group having a carbon number of 1 to 22, or an aryl group or heteroaryl group having a carbon number of 2 to 30.

X represents a single bond, a linear, cyclic or branched alkylene group having a carbon number of 1 to 22, or an arylene group or heteroarylene group having a carbon number of 2 to 30.

Ar represents an arylene group or heteroarylene group having a carbon number of 2 to 30, an arene-triyl group or heteroarene-triyl group having a carbon number of 2 to 30, or an arene-tetrayl group or heteroarene-tetrayl group having a carbon number of 2 to 30.

In the present embodiment, examples of the alkylene group include a methylene group, ethylene group, n-propylene group, n-butylene group, n-pentylene group, n-hexylene group, n-heptylene group, n-octylene group, n-nonylene group, n-decylene group, n-undecylene group, n-dodecylene group, isopropylene group, isobutylene group, sec-butylene group, tert-butylene group, 2-ethylhexylene group, 3,7-dimethyloctylene group, cyclohexylene group, cycloheptylene group and cyclooctylene group.

In the present embodiment, an arene-triyl group or heteroarene-triyl group, and an arene-tetrayl group or heteroarene-tetrayl group are atom groupings in which 3 or 4 hydrogen atoms respectively have been removed from an aromatic hydrocarbon or an aromatic compound having a hetero atom. Examples of these groups include groups in which an additional one or two hydrogen atoms have been removed from the specific examples of the arylene group and heteroarylene group described above.

From the viewpoint of improving the lifespan properties, R and R' are preferably linear, cyclic or branched alkyl groups having a carbon number of 1 to 22, and the carbon number is more preferably from 2 to 16, even more preferably from 3 to 12, and most preferably from 4 to 8. In terms of achieving a combination of good solubility in solvents and good wettability by the upper layer material, an n-butyl group, n-pentyl group, n-hexyl group, n-heptyl group, n-octyl group, n-nonyl group, n-decyl group, n-undecyl group, n-dodecyl group, isobutyl group, sec-butyl group, tert-butyl group, 2-ethylhexyl group, 3,7-dimethyloctyl group and cyclohexyl group are particularly desirable.

X is preferably a single bond or a linear, cyclic or branched alkylene group having a carbon number of 1 to 22, and is more preferably a single bond.

Ar is preferably an arylene group, arene-triyl group or arene-tetrayl group, and is more preferably a phenylene group, benzene-triyl group or benzene-tetrayl group.

### <Organic Groups (a2-1) to (a2-8)>

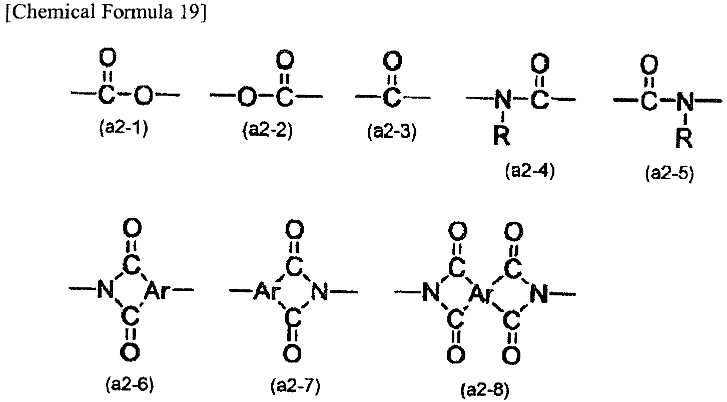

In the formulas, R represents a hydrogen atom, a linear, cyclic or branched alkyl group having a carbon number of 1 to 22, or an aryl group or heteroaryl group having a carbon number of 2 to 30.

Ar represents an arene-triyl group or heteroarene-triyl group having a carbon number of 2 to 30, or an arene-tetrayl group or heteroarene-tetrayl group having a carbon number of 2 to 30.

The polymer or oligomer (A) preferably includes the organic group (a1). When the polymer or oligomer (A) has the organic group (a1) in a terminal structural unit, then a specific example of that terminal structural unit is the structural unit (1c) having the organic group (a1) as a substituent. Further, when the polymer or oligomer (A) has the organic group (a1) in a non-terminal structural unit, specific examples of the non-terminal structural unit include the structural units (1) to (28) having the organic group (a1) as R.

### [Polymerizable Substituent (b)]

The polymer or oligomer (A) may have a substituent having a "polymerizable group" (namely, the polymerizable substituent (b)). The term "polymerizable group" describes a group that can form a bond between two or more molecules by initiating a polymerization reaction. As a result of this polymerization reaction, the solubility in solvents of the organic layer formed using the polymer or oligomer (A) changes, thereby facilitating formation of the upper layer by a wet process. When the expression "polymerizable substituent (b)" is used, this is also deemed to include the "polymerizable group" itself.

There are no particular limitations on the position of the polymerizable substituent (b) within the polymer or oligomer (A). Any position which enables the polymerizable substituent to form an intermolecular bond between two or more molecules by initiating a polymerization reaction is suitable. The polymer or oligomer (A) may contain the polymerizable substituent (b) within a terminal structural unit, within a non-terminal structural unit, or within both a terminal structural unit and a non-terminal structural unit. The polymer or oligomer (A) preferably includes the polymerizable substituent (b) within at least a terminal structural unit.

Examples of the polymerizable group include groups having a carbon-carbon multiple bond, groups having a cyclic structure, groups having an aromatic heterocyclic structure, groups containing a siloxane derivative, and combinations of two types of groups capable of forming an ester linkage or amide linkage.

Examples of the groups having a carbon-carbon multiple bond include groups having a carbon-carbon double bond and groups having a carbon-carbon triple bond, and specific examples include alkenyl groups such as an acryloyl group, acryloyloxy group, acryloylamino group, methacryloyl group, methacryloyloxy group, methacryloylamino group, vinyloxy group, vinylamino group, styryl group, allyl group, butenyl group, and vinyl group (but excluding the above groups); and alkynyl groups such as an ethynyl group.

Examples of the groups having a cyclic structure include groups having a cyclic alkyl structure, groups having a cyclic ether structure, lactone groups (groups having a cyclic ester structure) and lactam groups (groups having a cyclic amide structure), and specific examples include a cyclopropyl group, cyclobutyl group, cardene group (1,2-dihydrobenzocyclobutene group), epoxy group (oxiranyl group), oxetane group (oxetanyl group), diketene group, episulfide group, α-lactone group, β-lactone group, α-lactam group and β-lactam group.

Examples of the groups having an aromatic heterocyclic structure include a furanyl group, pyrrolyl group, thiophenyl group and silolyl group.

Examples of the combinations of two types of groups capable of forming an ester linkage or amide linkage include combinations of a carboxyl group and a hydroxyl group, and combinations of a carboxyl group and an amino group.

The polymerizable group is preferably a group having a cyclic structure, is more preferably a group having a cyclic ether structure, and is even more preferably an oxetane group.

From the viewpoint of obtaining superior curability, the number of polymerizable substituents (b) per single molecule of the polymer or oligomer (A) is preferably at least 2, and more preferably 3 or more. Further, in terms of the stability of the polymer or oligomer (A), the number of polymerizable substituents (b) is preferably not more than 1,000, more preferably not more than 500, and even more preferably 200 or fewer.

From the viewpoints of enhancing the degree of freedom of the polymerizable group and facilitating the polymerization reaction, the polymerizable substituent (b) preferably has an alkylene portion, and the polymerizable group is preferably bonded to this alkyl portion. Examples of the alkylene portion include linear alkyl portions such as methylene, ethylene, propylene, butylene, pentylene, hexylene, heptylene and octylene portions. The carbon number of the alkyl portion is preferably from 1 to 8.

From the viewpoint of improving the affinity with hydrophilic electrodes of ITO or the like, the polymerizable substituent (b) preferably has a hydrophilic portion, and the polymerizable group is preferably bonded to this hydrophilic portion. Examples of the hydrophilic portion include linear hydrophilic portions, including oxyalkylene structures such as an oxymethylene structure or oxyethylene structure, and polyalkyleneoxy structures such as a polyoxymethylene structure or polyoxyethylene structure. The carbon number of the hydrophilic portion is preferably from 1 to 8.

From the viewpoint of facilitating the preparation of the polymer or oligomer (A), the polymerizable substituent (b) may include an ether linkage or an ester linkage or the like in the linking portion between the alkylene portion or hydrophilic portion, and the polymerizable group and/or the atom grouping having the ability to transport an electric charge.

Specific examples of the polymerizable substituent (b) include the substituent groups (A) to (C) shown below.

### <Substituent Groups (A) to (C)>

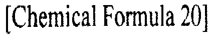

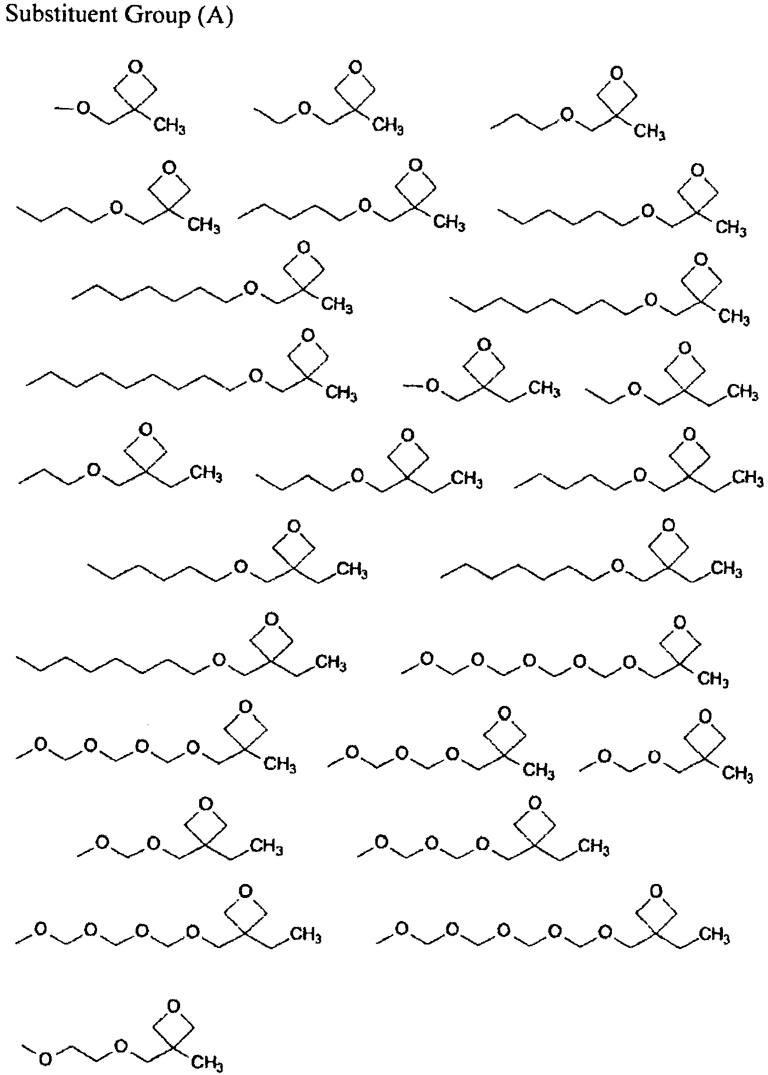

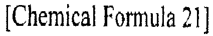

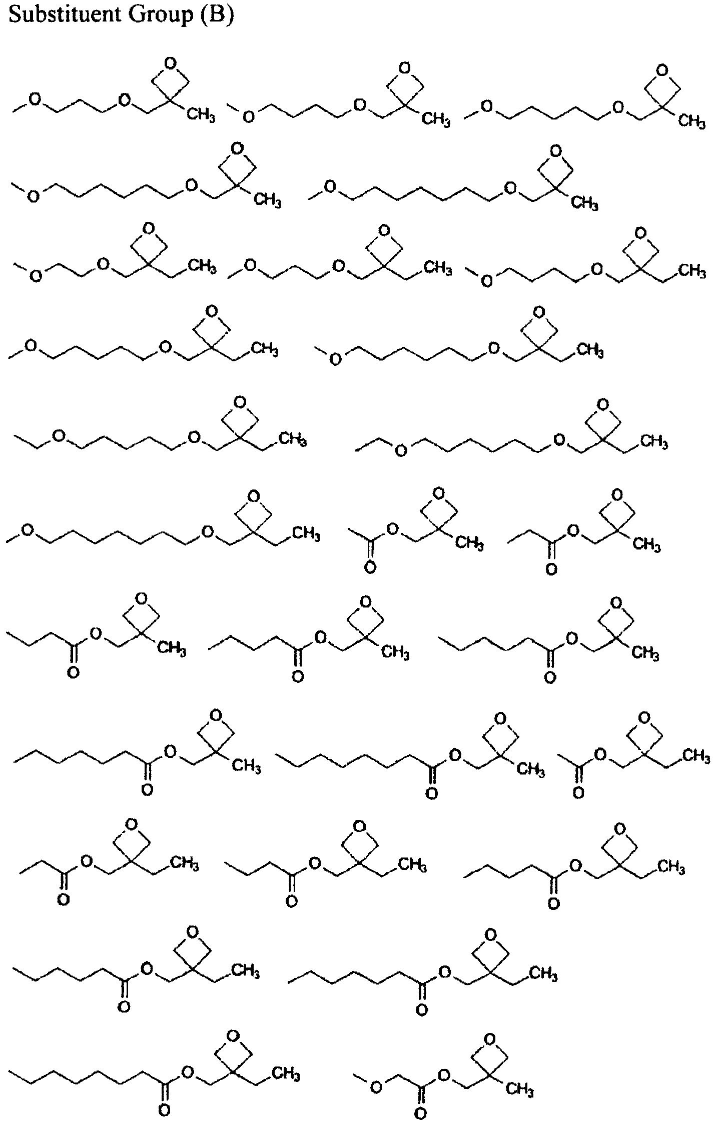

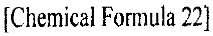

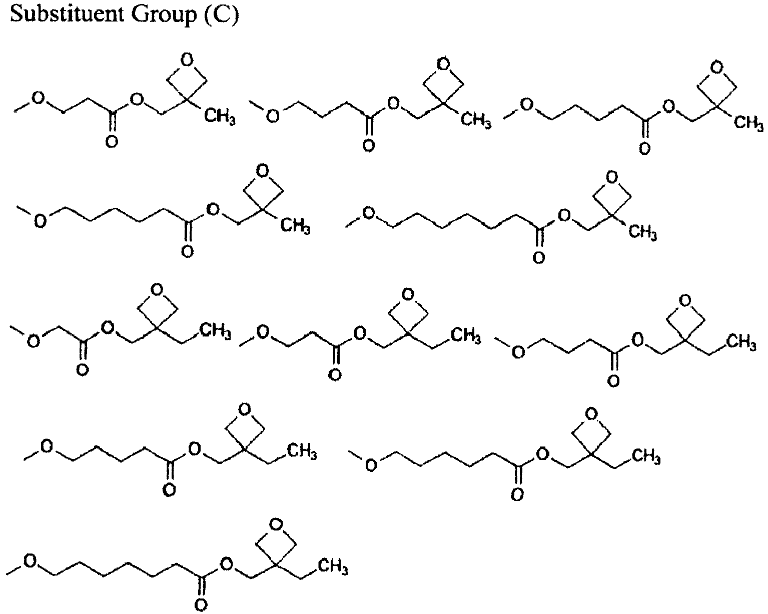

The polymer or oligomer (A) preferably has the polymerizable substituent (b) at a terminal of the molecular chain. In this case, the polymer or oligomer (A) has a structural unit containing the polymerizable substituent (b) as a terminal structural unit. A specific example is the structural unit (1c) having the polymerizable substituent (b).

The polymer or oligomer (A) may be a homopolymer having one type of structural unit, or a copolymer having two or more types of structural units. The copolymer may be an alternating, random, block or graft copolymer, or a copolymer having an intermediate type structure, such as a random copolymer having block-like properties.

From the viewpoints of suppressing crystallization and obtaining favorable film-forming properties, the weight-average molecular weight of the polymer or oligomer (A) is preferably at least 1,000, more preferably at least 2,000, and even more preferably 3,000 or greater. Further, from the viewpoints of improving the solubility in solvents and facilitating the preparation of the composition described below, the weight-average molecular weight of the polymer or oligomer (A) is preferably not more than 1,000,000, more preferably not more than 900,000, and even more preferably 800,000 or less. The "weight-average molecular weight" refers to the polystyrene standard-equivalent weight-average molecular weight determined by gel permeation chromatography (GPC).

In those cases where the polymer or oligomer (A) contains any of the structural units (1a) to (84a), from the viewpoint of obtaining superior hole transport properties, the proportion of the total number of the structural units (1a) to (84a) relative to the total number of all the structural units in the polymer or oligomer (A) is preferably at least 10%, more preferably at least 25%, and even more preferably 50% or higher. Further, the proportion of the total number of the structural units (1a) to (84a) may be 100%, but if consideration is given to factors such as facilitating the introduction of the organic group (a1) and/or the polymerizable substituent (b) at the terminals, then the proportion is preferably not more than 95%, more preferably not more than 90%, and even more preferably 80% or lower.

The "proportion of structural units" can be determined from the blend ratio (molar ratio) between the monomers corresponding with each of the structural units used in synthesizing the polymer or oligomer (A).

In those cases where the polymer or oligomer (A) contains any of the structural units (1 b) to (11b), from the viewpoint of improving the carrier transport properties, the proportion of the total number of the structural units (1b) to (11b) relative to the total number of all the structural units in the polymer or oligomer (A) is preferably at least 1%, more preferably at least 3%, and even more preferably 10% or higher. Further, in terms of preventing any deterioration in the yield due to gelling during synthesis, the proportion of the total number of the structural units (1b) to (11b) is preferably not more than 50%, more preferably not more than 30%, and even more preferably 25% or lower.

In those cases where the polymer or oligomer (A) contains any of the structural units (1) to (28), from the viewpoint of the lifespan of the organic electronic element, the proportion of the total number of the structural units (1) to (28) relative to the total number of all the structural units in the polymer or oligomer (A) is preferably at least 0.1%, more preferably at least 0.2%, and even more preferably 1.0% or higher. Further, from the viewpoint of the lifespan of the organic electronic element, the proportion of the structural unit (1b) is preferably not more than 40%, more preferably not more than 35%, and even more preferably 30% or lower.

When the polymer or oligomer (A) contains the structural unit (1c), from the viewpoint of the lifespan of the organic electronic element, the proportion of the structural unit (1c) relative to the total number of all the structural units in the polymer or oligomer (A) is preferably at least 0.1%, more preferably at least 0.2%, and even more preferably 1.0% or higher. Further, in terms of the lifespan of the organic electronic element, the proportion of the structural unit (1c) is preferably not more than 40%, more preferably not more than 35%, and even more preferably 30% or lower.

From the viewpoint of enhancing the lifespan of the organic electronic element, the proportion of the organic group (a) relative to the total number of all the structural units in the polymer or oligomer (A) is preferably at least 1%, more preferably at least 3%, and even more preferably 10% or higher. Further, in terms of the solubility of the polymer or oligomer (A), the proportion of the organic group (a) is preferably not more than 80%, more preferably not more than 60%, and even more preferably 40% or lower. Here, the "proportion of the organic group (a)" refers to the proportion of the structural unit containing the organic group (a), and is preferably the proportion of the structural unit having the organic group (a1).

In those cases where the polymer or oligomer (A) contains the polymerizable substituent (b), from the viewpoint of magnifying the change in solubility of the organic layer, the proportion of the polymerizable substituent (b) relative to the total number of all the structural units in the polymer or oligomer (A) is preferably at least 1%, more preferably at least 3%, and even more preferably 10% or higher. Further, in terms of reducing the effect on the energy levels of the hole transport portion, the proportion of the polymerizable substituent (b) is preferably not more than 80%, more preferably not more than 60%, and even more preferably 40% or lower. Here, the "proportion of the polymerizable substituent (b)" refers to the proportion of the structural unit containing the polymerizable substituent (b).

One preferred embodiment provides a polymer or oligomer (A) containing a structural unit with hole transport properties, and also containing a "structural unit having an organic group (a)". By using this polymer or oligomer (A), excellent lifespan properties can be obtained.

One preferred embodiment provides a polymer or oligomer (A) containing a structural unit with hole transport properties, and also containing a "structural unit having an organic group (a)" and a "structural unit having a polymerizable substituent (b) different from the organic group (a)". By using this polymer or oligomer (A), stacking of organic layers becomes easier, and excellent lifespan properties can be obtained. The form of the organic group (a) includes both "organic groups (a) containing a polymerizable group" and "organic groups (a) not containing a polymerizable group".

Further, another preferred embodiment provides a polymer or oligomer (A) containing a structural unit with hole transport properties, and also containing a "structural unit having an organic group (a) containing a polymerizable group". By using this polymer or oligomer (A), stacking of organic layers becomes easier, and excellent lifespan properties can be obtained. Further, because this polymer or oligomer (A) can provide excellent curability (low-temperature curability) while maintaining excellent hole transport properties, it can produce a combination of improved properties for the organic electronic element and improved productivity.

The polymer or oligomer (A) can be produced using various synthesis methods well known to those in the art. For example, in those cases where each of the monomer units used in the synthesis of the polymer or oligomer (A) has an aromatic ring, and the polymer or oligomer (A) is produced by bonding aromatic rings together, methods that can be used include those disclosed by T. Yamamoto et al., Bull. Chem. Soc. Jpn., vol. 51, No. 7, page 2091 (1978), M. Zembayashi et al., Tet. Lett., vol. 47, page 4089 (1977), and A. Suzuki, Synthetic Communications, vol. 11, No. 7, page 513 (1981). In particular, the method described by A. Suzuki is typical for the production of the polymer or oligomer (A). Monomers corresponding with each of the structural units described above can be used as the various monomers.

The method disclosed by A. Suzuki is a method of causing a cross-coupling reaction (commonly called the "Suzuki reaction") between an aromatic boronic acid derivative and an aromatic halide using a Pd catalyst. By using the desired aromatic rings in the coupling reaction, the polymer or oligomer (A) can be produced.

Further, in the Suzuki reaction, a soluble Pd compound such as a Pd(II) salt or a Pd(0) complex is typically used as the Pd catalyst. Examples of preferred Pd sources include Pd(Ph₃P)₄ and a Pd(OAc)₂ complex, a Pd₂(dba)₃ complex and a PdCl₂(dppf) complex with a tertiary phosphine ligand, which can be used in an amount of 0.01 to 5 mol% relative to the amount of aromatic ring-containing reactants.

In the Suzuki reaction, a base is typically also used, and the base is preferably an aqueous alkali carbonate or bicarbonate, or a tetraalkylammonium hydroxide. Further, a phase transfer catalyst may be used to promote the reaction in non-polar solvents. Examples of solvents that can be used include N,N-dimethylformamide, toluene, anisole, dimethoxyethane and tetrahydrofuran.

### [Composition]

The composition according to another embodiment of the present invention contains the polymer or oligomer (A) and a solvent (B). The composition may also include an ionic compound (C). The composition may contain only one type of each of these components, or may contain two or more types of each component.

### [Solvent (B)]

The composition contains the solvent (B). Any solvent that enables the composition to be used to form a coating layer may be used, and the use of a solvent that is capable of dissolving the polymer or oligomer (A), and the ionic compound (C) that is used as required, is preferable.

Examples of the solvent include water; alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetralin and diphenylmethane; aliphatic ethers such as ethylene glycol dimethyl ether, ethylene glycol diethyl ether and propylene glycol-1-monomethyl ether acetate; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; amides such as N,N-dimethylformamide and N,N-dimethylacetamide; as well as dimethyl sulfoxide, tetrahydrofuran, acetone, chloroform, methylene chloride and chlorobenzene. Aromatic hydrocarbons, aliphatic esters, aromatic esters, aliphatic ethers and aromatic ethers are preferred.

### [Ionic Compound (C)]

The composition may include an ionic compound (C). The ionic compound is a compound containing at least one type of anion and at least one type of cation. The ionic compound usually includes the anion(s) and the cation(s) in a state where the charges of the anion(s) and the cation(s) are balanced. By using the ionic compound, the hole transport properties of the organic layer formed using the polymer or oligomer (A) can be improved. Further, the ionic compound can also act as a polymerization initiator for polymerizable groups, and can therefore efficiently accelerate the polymerization reaction. Examples of the cation and anion are presented below.

### [Cation]

Examples of the cation include H⁺, a carbenium ion, ammonium ion, anilinium ion, pyridinium ion, imidazolium ion, pyrrolidinium ion, quinolinium ion, imonium ion, aminium ion, oxonium ion, pyrylium ion, chromenylium ion, xanthylium ion, iodonium ion, sulfonium ion, phosphonium ion, tropylium ion and cations having a transition metal, and of these, a carbenium ion, ammonium ion, anilinium ion, aminium ion, iodonium ion, sulfonium ion or tropylium ion is preferable. From the viewpoint of achieving a favorable combination of change in the solubility of the organic layer and storage stability, an ammonium ion, anilinium ion, iodonium ion or sulfonium ion is more preferable, and an iodonium ion is particularly preferred. Examples of iodonium ions include diphenyliodonium, di-p-tolyliodonium, bis(4-dodecylphenyl)iodonium, bis(4-methoxyphenyl)iodonium, (4-octyloxyphenyl)phenyliodonium, bis(4-decyloxyphenyl)iodonium, 4-(2-hydroxytetradecyloxy)phenylphenyliodonium, 4-isopropylphenyl(p-tolyl)iodonium and isobutylphenyl(p-tolyl)iodonium ions.

### [Anion]

Examples of the anion include halogen ions such as F⁻, Cl⁻, Br⁻ and I⁻; OH⁻; ClO₄⁻; sulfonate ions such as FSO₃⁻, ClSO₃⁻, CH₃SO₃⁻, C₆H₅SO₃⁻ and CF₃SO₃⁻; sulfate ions such as HSO₄⁻ and SO₄²⁻; carbonate ions such as HCO₃⁻ and CO₃²⁻; phosphate ions such as H₂PO₄⁻, HPO₄²⁻ and PO₄³⁻; fluorophosphate ions such as PF₆⁻ and PF₅OH⁻; fluoroalkyl fluorophosphate ions such as [(CF₃CF₂)₃PF₃]⁻, [(CF.,CF₂CF₂)₃PF₃]⁻, [((CF₃)₂CF)₃PF₃]⁻, L((CF₃)₂CF)₂PF₄]⁻, [((CF₃)₂CFCF₂)₃PF₃]⁻ and [((CF₃)₂CFCF₂)₂PF_{4]}⁻; fluoroalkane sulfonyl methide or imide ions such as (CF₃SO₂)₃)C⁻ and (CF₃SO₂)₂N⁻; borate ions such as BF₄⁻, B(C₆F₅)₄⁻ and B(C₆H₄CF₃)₄⁻; fluoroantimonate ions such as SbF₆⁻ and SbF₅OH⁻; fluoroarsenate ions such as AsF₆⁻ and AsF₅OH⁻; AlCl₄⁻ and BiF₆⁻. From the viewpoint of the change in the solubility of the organic layer when used in combination with the aforementioned cation, fluorophosphate ions such as PF₆⁻ and PF₅OH⁻; fluoroalkyl fluorophosphate ions such as [(CP₃CF₂)₃PF₃]⁻, [(CF₃CF₂CF₂)₃PF_{3]}⁻, [((CF₃)₂CF)₃PF₃]⁻, [((CF₃)₂CF)₂PF₄)⁻, [((CF₃)₂CFCF₂)₃PF₃]⁻ and [((CF₃)₂CFCF₂)₂PF₄]⁻; fluoroalkane sulfonyl methide or imide ions such as (CF₃SO₂)₃C⁻ and (CF₃SO₂)₂N⁻; borate ions such as BF₄⁻, B(C₆F₅)₄⁻ and B(C₆H₄CF₃)₄⁻; and fluoroantimonate ions such as SbF₆⁻ and SbF₅OH⁻ are preferable, and among these, a borate ion is particularly preferable.

More specifically, an ionic compound containing one type of cation selected from among an ammonium ion, anilinium ion, iodonium ion and sulfonium ion, and one type of anion selected from among fluorophosphate ions, fluoroalkyl fluorophosphate ions, fluoroalkane sulfonyl methide or imide ions, borate ions and fluoroantimonate ions is preferable. Specific examples of the anion and cation incorporated within this preferred ionic compound are not limited to those mentioned above, and conventional anions and cations may also be used.

In those cases where the polymer or oligomer (A) contains a polymerizable group, even if the composition does not contain the ionic compound (C), the polymer or oligomer (A) can still be polymerized by reacting the polymerizable group under light irradiation and/or heating. When the composition does contain the ionic compound (C), the change in the solubility of the organic layer tends to be magnified. Further, the polymerizable group can be reacted at low temperature and with heating for only a short period of time. From the viewpoint of facilitating the stacking of layers using wet processes, the composition preferably contains the ionic compound (C).

The amount of the polymer or oligomer (A) in the composition can be determined with due consideration of application of the composition to a variety of coating methods. For example, the amount of the polymer or oligomer (A) is preferably at least 0.1 % by mass, more preferably at least 0.2% by mass, and even more preferably 0.5% by mass or greater. Further, the amount of the polymer or oligomer (A) is preferably not more than 10% by mass, more preferably not more than 5% by mass, and even more preferably 3% by mass or less.

In those cases where the composition contains the ionic compound (C), from the viewpoint of enhancing the hole transport properties, or changing the solubility of the organic layer to facilitate the stacking of layers, the amount of the ionic compound (C), relative to the polymer or oligomer (A), is preferably at least 0.1% by mass, more preferably at least 0.2% by mass, and even more preferably 0.5% by mass or greater. Further, from the viewpoint of preventing any deterioration in the element properties caused by the retention of substances derived from the ionic compound (C) in the organic layer, the amount of the ionic compound (C) is preferably not more than 30% by mass, more preferably not more than 25% by mass, and even more preferably 20% by mass or less. Examples of substances derived from the ionic compound (C) include the ionic compound (C) itself, and decomposition or reaction products of the ionic compound (C).

### [Hole Transport Material Composition]

Another embodiment of the present invention relates to a hole transport material composition containing the above composition.

The hole transport material composition contains the polymer or oligomer (A) and the ionic compound (C) as required, as well as a solvent (B) capable of dissolving or dispersing these components. Because this composition contains the polymer or oligomer (A) that has the structural unit with hole transport properties described above, it can be used favorably as a hole transport material composition in the formation of organic electronic elements such as organic EL elements and organic photoelectric conversion elements. The hole transport material composition may also include a low-molecular weight compound or a substance that can act as a dopant or the like.

### [Ink Composition]

Furthermore, yet another embodiment of the present invention relates to an ink composition containing the above composition.

The ink composition contains the polymer or oligomer (A) and the ionic compound (C) as required, as well as a solvent (B) capable of dissolving or dispersing these components. The ink composition may also contain other additives such as polymerization inhibitors, stabilizers, thickeners, gelling agents, flame retardants, antioxidants, reduction inhibitors, oxidizing agents, reducing agents, surface improvers, emulsifiers, antifoaming agents, dispersants and surfactants.

### [Organic Layer]

Yet another embodiment of the present invention relates to an organic layer formed from the aforementioned composition, hole transport material composition or ink composition. The organic layer can be formed by applying one of these compositions to an arbitrary electrode or layer or the like.

Examples of the coating method include conventional methods such as spin coating methods, casting methods, dipping methods, plate-based printing methods such as relief printing, intaglio printing, offset printing, lithographic printing, letterpress inversion offset printing, screen printing and gravure printing, and plateless printing methods such as inkjet methods. The coating is typically performed at a temperature within a range from -20 to +300°C, preferably from 10 to 100°C, and particularly preferably from 15 to 50°C. Further, following coating, the obtained organic layer may be dried on a hotplate or in an oven to remove the solvent, typically at a temperature within a range from +30 to +300°C, preferably from 60 to 250°C, and particularly preferably from 80 to 220°C. The drying time is typically from 10 seconds to 2 hours, preferably from 1 minute to 1 hour, and particularly preferably from 1 to 10 minutes.

In those cases where the polymer or oligomer (A) has a polymerizable group, heat, light, or both heat and light may be applied to the organic layer formed by the coating process to obtain an organic layer having different solubility from that prior to the application of the heat and/or light.

For the light irradiation, light sources such as a low-pressure mercury lamp, medium-pressure mercury lamp, high-pressure mercury lamp, ultra high-pressure mercury lamp, metal halide lamp, xenon lamp, fluorescent lamp, light-emitting diode or sunlight can be used. The wavelength of the irradiated light is, for example, from 200 to 800 nm.

A hotplate or an oven can be used for the heating. The heating temperature is preferably from 60 to 300°C, more preferably from 80 to 250°C, and even more preferably from 100 to 220°C. The heating time is preferably from 10 seconds to 2 hours, more preferably from 1 minute to 1 hour, and particularly preferably from 1 to 10 minutes.

Because the organic layer to which heat, light, or both heat and light has been applied has low solubility in solvents, another organic layer (the upper layer) can easily be formed on top of the organic layer of the present embodiment (the lower layer) using a coating solution. Further, because the polymer or oligomer (A) contains the organic group (a), an organic layer (upper layer) of excellent uniformity can be obtained. Examples of solvents that can be used in the coating solution include not only the solvents mentioned above as the solvent (B), but also the solvents disclosed in JP 2012-531012 A (for example, aromatic ketones such as 1-tetralone and 2-tetralone, and aromatic ethers such as 3-phenoxytoluene and butoxybenzene), the solvents disclosed in JP 2006-66294 (for example, mixed solvents containing aromatic compounds such as o-xylene and 1,3,5-trimethylbenzene or anisole and anisole derivatives such as 4-methylanisole, and polyvalent alcohol compounds such as 2-ethyl-1-butanol and 2-ethyl-1-hexanol), and the solvents disclosed in JP 2010-157751 A (including benzene derivatives such as mesitylene, cumene and dodecylbenzene (non-polar solvents), polar solvents such as a-butyrolactone, N-methylpyrrolidone, 1,3-dimethyl-2-imidazolidinone and derivatives thereof, and glycol ethers, and mixtures of these solvents). Further, the composition described above may also be used as the coating solution.

The thickness of the organic layer can be set appropriately in accordance with the intended use. For example, the thickness can be set within a range from 5 nm to 10 µm. Particularly in those cases when the organic layer is used for a hole injection layer, a hole transport layer and/or a hole injection and transport layer of an organic EL element, from the viewpoint of moderating surface roughness on the anode and reducing the chance of short-circuits, the thickness of the organic layer is preferably at least 5 nm, more preferably 10 nm or greater, and even more preferably 20 nm or greater. Further, from the viewpoint of reducing the drive voltage of the organic EL element, the thickness of the organic layer is preferably not more than 500 nm, more preferably not more than 200 nm, and even more preferably 100 nm or less.

### [Organic Electronic Element, Display Element, Illumination Device, Display Device]

Further, other embodiments of the present invention relate to organic electronic elements such as an organic EL element and an organic photoelectric conversion element having the aforementioned organic layer. The organic electronic element contains at least two electrodes, and has the organic layer positioned between the electrodes.

Moreover, yet other embodiments of the present invention relate to a display element, an illumination device and a display device which use the organic EL element.

### [Organic EL Element]

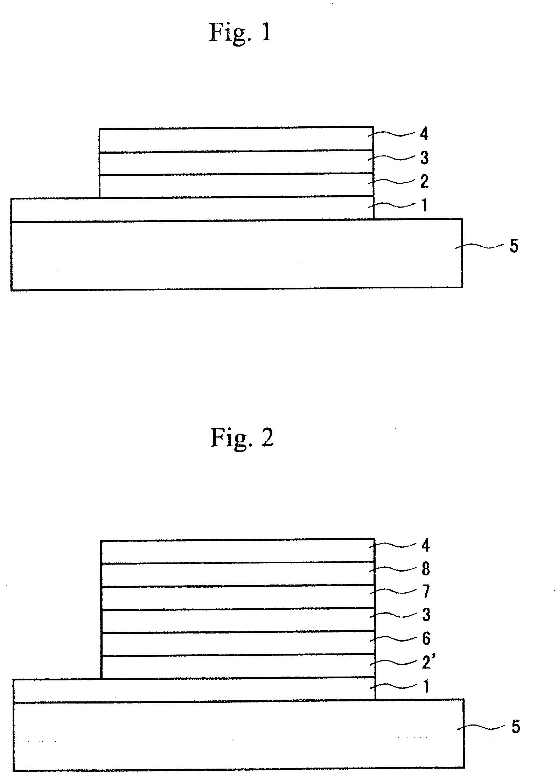

The organic EL element according to one embodiment of the present invention contains the organic layer described above. The organic EL element typically contains a light-emitting layer, an anode, a cathode and a substrate, and may also contain one or more other layers such as a hole injection layer, electron injection layer, hole transport layer, electron transport layer, hole injection and transport layer, or electron injection and transport layer. The organic EL element has at least the organic layer described above, and for example, the organic layer can be used as the light-emitting layer and as other layers, and is preferably used as a hole injection layer, a hole transport layer, and/or a hole injection and transport layer. Accordingly, one example of the organic EL element has, in sequence, an anode, the organic layer which functions as a hole injection layer, a hole transport layer and/or a hole injection and transport layer, a light-emitting layer and a cathode, and may also include other optional layers between these layers. Examples of the organic EL element are shown in FIG. 1 and FIG. 2.

For example, the organic EL element can be prepared by forming the organic layer described above as a hole injection layer, a hole transport layer and/or a hole injection and transport layer, and then completing preparation in accordance with the method disclosed in JP 2012-531012 A, JP 2006-66294 A or JP 2010-157751 A or the like. Further, the organic EL layer may also be prepared by forming each of the layers described below.

### [Light-Emitting Layer]

The material used for the light-emitting layer may be a low-molecular weight compound, or a polymer or oligomer, and a dendrimer or the like may also be used. Examples of low-molecular weight compounds that utilize fluorescence include perylene, coumarin, rubrene, quinacridone, dyes for dye lasers (such as rhodamine and DCM1), aluminum complexes (such as tris(8-hydroxyquinolinato)aluminum(III) (Alq₃)), stilbene, and derivatives of these compounds. Examples of polymers or oligomers that utilize fluorescence include polyfluorene, polyphenylene, polyphenylene vinylene (PPV), polyvinylcarbazole (PVK), fluorene-benzothiadiazole copolymers, fluorene-triphenylamine copolymers, and derivatives and mixtures and the like thereof.

On the other hand, in recent years, the development of phosphorescent organic EL elements is also being actively pursued, with the aim of increasing the efficiency of organic EL elements. In a phosphorescent organic EL element, not only the energy from a singlet state, but also the energy from a triplet state can be utilized, and the internal quantum yield can be raised to 100% in principle. In a phosphorescent organic EL element, a metal complex-based phosphorescent material containing a heavy metal such as platinum or iridium is used as a phosphorescence-generating dopant for doping the host material, thus enabling the extraction of phosphorescent emission (see M.A. Baldo et al., Nature, vol. 395, page 151 (1998), M.A. Baldo et al., Applied Physics Letters, vol. 75, page 4 (1999), and M.A. Baldo et al., Nature, vol. 403, page 750 (2000)).

Similarly, in the organic EL element that represents an embodiment of the present invention, a phosphorescent material can be used for the light-emitting layer from the viewpoint of improving the efficiency. Metal complexes and the like containing a central metal such as Ir or Pt can be used favorably as the phosphorescent material. Specific examples of Ir complexes include Flr(pic) [iridium(III) bis[(4,6-difluorophenyl)-pyridinato-N,C²]picolinate] which emits blue light, Ir(ppy)₃ [fac tris(2-phenylpyridine)iridium] (see M.A. Baldo et al., Nature, vol. 403, page 750 (2000)) which emits green light, and (btp)₂Ir(acac) {bis[2-(2'-benzo[4,5-α]thienyl)pyridinato-N,C³]iridium(acetyl acetonate)} (see Adachi et al., Appl. Phys. Lett., 78, No. 11, page 1622 (2001)) or Ir(piq)₃ [tris(1-phenylisoquinoline)iridium] which emit red light. A specific example of a Pt complex is 2,3,7,8,12,13,17,18-octaethyl-21H,23H-porphine platinum (PtOEP) which emits red light. A low-molecular weight material or a dendrite such as an iridium core dendrimer can be used as the phosphorescent material. Further, derivatives of these compounds can also be used.

Further, when the light-emitting layer contains a phosphorescent material, the layer preferably also contains a host material besides the phosphorescent material. The host material may be a low-molecular weight compound, a polymer or oligomer, or a dendrimer or the like.

Examples of compounds that can be used as the low-molecular weight compound include CBP (4,4'-bis(carbazol-9-yl)-biphenyl), mCP (1,3-bis(9-carbazolyl)benzene), CDBP (4,4'-bis(carbazol-9-yl)-2,2'-dimethylbiphenyl), and α-NPD (4,4'-bis[(1-naphthyl)phenylaimino]-1,1'-biphenyl). Examples of the polymer or oligomer include polyvinylcarbazole, polyphenylene and polyfluorene, and derivatives of these compounds can also be used.

The light-emitting layer may be formed by a vapor deposition method or a coating method.

When the light-emitting layer is formed by a coating method, the organic EL element can be produced inexpensively, which is preferable. In order to form the light-emitting layer by a coating method, a solution containing the phosphorescent material, and where necessary a host material, can be applied to a desired substrate using a conventional coating method. Examples of the coating method include spin coating methods, casting methods, dipping methods, plate-based printing methods such as relief printing, intaglio printing, offset printing, lithographic printing, letterpress inversion offset printing, screen printing and gravure printing, and plateless printing methods such as inkjet methods.

### [Cathode]

The cathode material is preferably a metal or metal alloy such as Li, Ca, Mg, Al, In, Cs, Ba, Mg/Ag, LiF or CsF.

### [Anode]

A metal (for example, Au) or another material having metal-like conductivity can be used as the anode. Examples of these other materials include oxides (for example, ITO: indium oxide/tin oxide) and conductive polymers (for example, polythiophene-polystyrene sulfonic acid mixtures (PEDOT:PSS)).

### [Electron Transport Layer, Electron Injection Layer, Electron Injection and Transport Layer]

Examples of the electron transport layer and electron injection layer include phenanthroline derivatives (for example, 2,9-dimethyl-4,7-diphenyl-1,10-phenanthroline (BCP)), bipyridine derivatives, nitro-substituted fluorene derivatives, diphenylquinone derivatives, thiopyran dioxide derivatives, condensed ring tetracarboxylic anhydrides of naphthalene and perylene and the like, carbodiimide, fluorenylidine methane derivatives, anthraquinodimethane and anthrone derivatives, oxadiazole derivatives (for example, 2-(4-biphenylyl)-5-(4-tert-butylphenyl-1,3,4-oxadiazole) (PBD)), and aluminum complexes (for example, tris(8-hydroxyquinolinato)aluminum(III) (Alq₃) and bis(2-methyl-8-quinolinato)-4-phenylphenolate aluminum(III) (BAlq)). Moreover, thiadiazole derivatives in which the oxygen atom in the oxadiazole ring of the aforementioned oxadiazole derivatives has been substituted with a sulfur atom, and quinoxaline derivatives having a quinoxaline ring that is known as an electron-withdrawing group, can also be used.

### [Substrate]

There are no particular limitations on the types of glass and plastic and the like that can be used as the substrate for the organic EL element. A flexible substrate is preferable. Further, a transparent substrate is also preferable, and glass, quartz, and optically transparent resin films and the like can be used favorably. When a resin film is used, the organic EL element can be imparted with flexibility (namely, a flexible substrate), which is particularly desirable.

Examples of the resin film include films formed from polyethylene terephthalate (PET), polyethylene naphthalate (PEN), polyethersulfone (PES), polyetherimide, polyetheretherketone, polyphenylene sulfide, polyarylate, polyimide, polycarbonate (PC), cellulose triacetate (TAC) and cellulose acetate propionate (CAP).

Further, when a resin film is used, in order to prevent the permeation of water vapor and oxygen and the like, the resin film may be coated with an inorganic substance such as silicon oxide or silicon nitride prior to use.

### [Sealing]

The organic EL element that represents an embodiment of the present invention may be sealed in order to reduce the effects of the external atmosphere and extend the lifespan of the element. Examples of materials that can be used for the sealing include glass, plastic films such as epoxy resins, acrylic resins, PET and PEN, and inorganic substances such as silicon oxide and silicon nitride.

There are no particular limitations on the sealing method, and examples of methods that can be used include a method in which the sealing material is formed directly on the organic EL element by vacuum deposition, sputtering or a coating method or the like, and a method in which glass or a plastic film is bonded to the organic EL element using an adhesive.

### [Emission Color]

There are no particular limitations on the light emission color from the organic EL element, but a white light-emitting element can be used for household illumination, in-vehicle illumination, and in various illumination devices such as clocks or liquid crystal backlights, and is consequently preferred.

Currently, achieving white light emission with a single material is difficult, and therefore the method of forming a white light-emitting element typically involves using a plurality of light-emitting materials to simultaneously emit a plurality of light colors, and then mixing these colors to obtain a white light emission. There are no particular limitations on the plurality of emission colors that are combined, and examples include combinations containing three maximum emission wavelengths of blue, green and red, and combinations containing two maximum emission wavelengths that utilize a complementary color relationship, such as blue and yellow, or yellow-green and orange. Furthermore, the emission color can be controlled by altering the type and amount of the phosphorescent material.

### [Display Element, Illumination Device, Display Device]

A display element that represents one embodiment of the present invention includes the organic EL element described above.

For example, by using an aforementioned organic EL element as the element corresponding with each pixel of red, green and blue (RGB), a color display element can be obtained.

Image formation systems include simple matrix systems in which the organic EL elements arranged in the panel are driven directly by electrodes disposed in a matrix arrangement, and active matrix systems in which a thin-film transistor is provided and driven in each element. The former system has a simple structure, but there is a limit to the number of vertical pixels, and therefore this type of system is typically used for displaying text or the like. The latter system has a low drive voltage, requires minimal current, and yields bright and very detailed images, and is therefore used for high-quality displays.

Furthermore, an illumination device that represents one embodiment of the present invention includes the organic EL element described above. Moreover, a display device that represents another embodiment of the present invention includes the illumination device, and a liquid crystal element as a display unit. A display device in which the above illumination device is used as the backlight (white light emission source) and a liquid crystal element is used as the display unit, namely a liquid crystal display device, may also be formed. This configuration is merely a conventional liquid crystal display device in which only the backlight has been replaced with the illumination device described above, and the liquid crystal element unit can employ conventional technology.

### [Organic Photoelectric Conversion Element]

Examples of organic photoelectric conversion elements include organic solar cells and organic optical sensors, and these elements typically contain a photoelectric conversion layer, electrodes and a substrate. Moreover, for the purpose of improving the conversion efficiency or the stability within air, the element may further contain one or more other layers such as a buffer layer or electron transport layer. The organic photoelectric conversion element contains at least the organic layer described above, wherein the organic layer can be used as the photoelectric conversion layer or a buffer layer, and is preferably used as a buffer layer. Accordingly, one example of the organic photoelectric conversion element contains, in sequence, an anode, the organic layer as a buffer layer, a photoelectric conversion layer, and a cathode, and may also include other optional layers between these layers. The structure of the organic photoelectric conversion element is described below in further detail.

### [Photoelectric Conversion Layer]

Any material that absorbs light, causes a charge separation, and generates an electromotive force can be used for the photoelectric conversion layer. In particular, from the viewpoint of conversion efficiency, a mixture obtained by blending a p-type organic semiconductor and an n-type organic semiconductor is preferable.

Examples of materials that can be used favorably as the p-type organic semiconductor include polymers or oligomers such as oligothiophene, polyalkylthiophene, poly(3-hexylthiophene) (P3HT) and polyphenylene vinylene (PPV); porphyrin, phthalocyanine and copper phthalocyanine; and derivatives of these compounds.

Examples of materials that can be used favorably as the n-type organic semiconductor include -CN group-containing or -CF₃ group-containing polymers or oligomers such as CN-poly(phenylene-vinylene) (CN-PPV), MEH-CN-PPV, and -CF₃ substituted polymers thereof; polymers or oligomers such as poly(fluorene) derivatives and fluorene-benzothiadiazole copolymers; fullerene (C₆₀), [6,6]-phenyl-C₆₁-butyric acid methyl ester (PCBM), [6,6]-phenyl-C₇₁-butyric acid methyl ester (PCBM), naphthalene tetracarboxylic dianhydride (NTCDA), perylene tetracarboxylic dianhydride (PTCDA), naphthalene tetracarboxylic diimide, perylene tetracarboxylic diimide, quinacridone; and derivatives of these compounds.

There are no particular limitations on the method used for forming the photoelectric conversion layer, and the layer may be formed by a vapor deposition method or a coating method. Formation by a coating method enables the organic photoelectric conversion element to be produced inexpensively, and is therefore preferred. Examples of methods that can be used for forming the photoelectric conversion layer by a coating method include the same methods as those mentioned above for forming the light-emitting layer.

### [Other Layers]

Besides the photoelectric conversion layer, the organic photoelectric conversion element also has a buffer layer as mentioned above, and may also contain an electron transport layer or the like. The organic layer described above can be used as the buffer layer, and LiF, TiOx or ZnOx or the like is generally used for the electron transport layer.

### [Electrodes]

Any material that exhibits conductivity can be used as the electrodes. Examples of materials for the electrodes include metals such as platinum, gold, silver, aluminum, chromium, nickel, copper, titanium, magnesium, calcium, barium, sodium and lithium fluoride, or alloys or salts of these metals; metal oxides such as indium oxide and tin oxide, or an alloy thereof (ITO); conductive polymers such as polyaniline, polypyrrole, polythiophene and polyacetylene; the above conductive polymers containing an added dopant, including an acid such as hydrochloric acid, sulfuric acid or sulfonic acid, a Lewis acid such as FeCl₃, halogen atoms such as iodine, or metal atoms such as sodium or potassium; and conductive composite materials in which metal particles or conductive particles of carbon black, fullerene or carbon nanotubes are dispersed within a matrix such as a polymer binder. A combination of these materials may also be used.

Further, at least one pair of (two) electrodes is provided, and at least one of the electrodes is a transparent electrode. Examples of the transparent electrode include oxides such as indium tin oxide (ITO), and indium zinc oxide (IZO); metal thin films; and conductive polymers such as PEDOT:PSS.

The electrodes have the function of collecting the holes and electrons generated inside the photoelectric conversion layer, and the use of a pair of electrode materials that are ideal for collecting holes and electrons respectively is preferable. Examples of electrode materials that are ideal for collecting holes include materials having a high work function such as Au and ITO. On the other hand, examples of electrodes that are ideal for collecting electrons include materials having a low work function such as Al.

There are no particular limitations on the method used for forming the electrodes, and methods such as vacuum deposition, sputtering and coating methods can be used.

### [Substrate]

Any material that is capable of supporting each of the layers can be used as the substrate. Examples of the material for the substrate include inorganic materials such as glass; organic materials such as polyethylene terephthalate (PET), polyethylene naphthalate (PEN), polyethersulfone (PES), polyimide (PI), polyetherimide (PEI), cycloolefin polymer (COP), polyphenylene sulfide (PPS), nylon, polystyrene, polyethylene, polypropylene, polyvinyl alcohol, fluororesin, polyvinyl chloride, cellulose, polyvinylidene chloride, aramid, polyurethane, polycarbonate, polyarylate, polynorbornene and polylactic acid; and composite materials including metals such as stainless steel, titanium or aluminum which have been surface-coated or laminated in order to impart insulating properties. Further, in order to impart gas barrier properties, a substrate that has been laminated with an inorganic substance such as silicon oxide or silicon nitride may also be used.

In particular, films formed from organic materials such as PET, PEN, PES, PI, PEI, COP and PPS provide good transparency and flexibility, and are consequently preferred.

### [Sealing]

The organic photoelectric conversion element that represents an embodiment of the present invention may be sealed using the same methods as those described above for the organic EL element in order to reduce the effects of the external atmosphere and extend the lifespan of the element.

### Examples

The embodiments of the present invention are described below based on a series of examples, but the present invention is in no way limited by these examples.

### [Polymers Having an Organic Group (a) in a Terminal Structural Unit]

### [Preparation of Organic EL Elements]

### (Example 1)

### (Preparation of Pd Catalyst)

In a glove box under a nitrogen atmosphere and at room temperature, tris(dibenzylideneacetone)dipalladium (73.2 mg, 80 µmol) was weighed into a sample tube, anisole (15 mL) was added, and stirring was performed for 30 minutes. In a similar manner, tri-tert-butylphosphine (129.6 mg, 640 µmol) was weighed into a sample tube, anisole (5 mL) was added, and stirring was performed for 5 minutes. These solutions were then mixed and stirred at room temperature for 30 minutes to form a catalyst. All solvents were deaerated by nitrogen bubbling for at least 30 minutes prior to use.

### (Polymer Synthesis)

A three-neck round-bottom flask was charged with a monomer 1 (1.5 mmol), a monomer 2 (2.5 mmol) and a monomer 3 (2.0 mmol) shown in Table 1, and anisole (20 mL), and the prepared Pd catalyst solution (1.0 mL) was then added. Following stirring of the mixture for 30 minutes, a 10% by mass aqueous solution of tetraethylammonium hydroxide (12 mL) was added. All solvents were deaerated by nitrogen bubbling for at least 30 minutes prior to use. The resulting mixture was heated under reflux for 2 hours. All operations up until this point were conducted under a stream of nitrogen.

Following completion of the reaction, the organic layer was washed with water, and the organic layer was then poured into methanol-water (9:1). The precipitate that was produced was collected by suction filtration, and washed with methanol-water (9:1). The thus obtained precipitate was dissolved in toluene, and then reprecipitated from methanol. The thus obtained precipitate was collected by suction filtration and dissolved in toluene, and a metal adsorbent (triphenylphosphine, polymer-bound on styrene-divinylbenzene copolymer, manufactured by Strem Chemicals Inc., 200 mg per 100 mg of precipitate) was then added to the solution and stirred overnight. Following completion of the stirring, the metal adsorbent and any insoluble matter was removed by filtration, and the filtrate was concentrated using a rotary evaporator. The resulting concentrate was dissolved in toluene, and then reprecipitated from methanol-acetone (8:3). The produced precipitate was collected by suction filtration, and washed with methanol-acetone (8:3). The thus obtained precipitate was dried under vacuum to obtain a polymer. The weight-average molecular weight was 6,000, and the yield was 55%. The polymer had a structural unit (1a) (derived from the monomer 1 and the monomer 2) and a structural unit (1c) having an organic group (a) (derived from the monomer 3), and the relative proportions of those structural units were 66.7% and 33.3% respectively.

The weight-average molecular weight was measured by GPC (relative to polystyrene standards) using tetrahydrofuran (THF) as the eluent. The measurement conditions were as follows.

Feed pump: L-6050, manufactured by Hitachi High-Technologies Corporation
UV-Vis detector: L-3000, manufactured by Hitachi High-Technologies Corporation
Columns: Gelpack ^{(R)} GL-A160S / GL-A150S, manufactured by Hitachi Chemical Co., Ltd.
Eluent: THF (for HPLC, stabilizer-free), manufactured by Wako Pure Chemical Industries, Ltd.
Flow rate: 1 mL/min
Column temperature: room temperature
Molecular weight standards: standard polystyrenes

### (Preparation of Organic EL Element)

The polymer (10 mg), an ionic compound 1 shown below (0.5 mg) and toluene (1,000 µL) were mixed together to prepare a composition. This composition was spin-coated at a rotational rate of 3,000 min⁻¹ onto a glass substrate (length 22 mm × width 29 mm × thickness 0.7 mm) coated with an ITO pattern having a width of 1.6 mm, thus forming a thin film (organic layer). The solvent was removed from the thin film by heating on a hotplate at 180°C for 10 minutes, thereby forming a hole injection and transport layer (thickness: 30 nm).

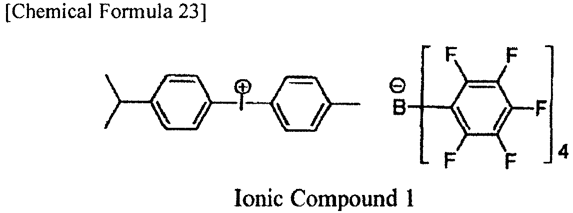

The thus obtained glass substrate was transferred into a vacuum deposition apparatus, and α-NPD (thickness: 30 nm), CBP+Ir(ppy)₃ (100:6, thickness: 30 nm), BAlq (thickness: 10 nm), Alq₃ (thickness: 30 nm), LiF (thickness: 0.8 nm) and Al (thickness: 150 nm) were deposited sequentially onto the substrate.

Following this vacuum deposition, the glass substrate was transferred into a dry nitrogen environment without exposure to the external atmosphere. A sealing glass formed from an alkali-free glass of thickness 0.7 mm provided with a concave portion having a depth of 0.4 mm and the glass substrate were bonded together using a photocurable epoxy resin, thereby sealing the substrate and completing preparation of an organic EL element having a multilayer structure.

### (Examples 2 to 4, and Comparative Example 1)

With the exception of using the monomers shown in Table 1, polymers were synthesized in the same manner as Example 1. The weight-average molecular weight and the yield of each polymer are shown in Table 2. Using the thus obtained polymers, organic EL elements were prepared in the same manner as Example 1. In the tables, the symbol "↑" means "the same as above".

### [Table 1]

**Table 1**

| | Monomer 1 | Monomer 2 | Monomer 3 |
|---|---|---|---|
| Example 1 | 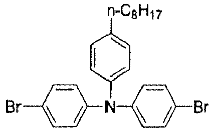 | 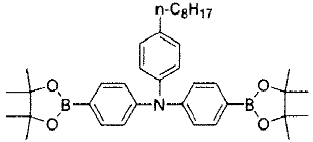 | 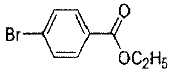 |
| Example 2 | ↑ | ↑ | 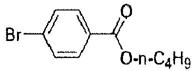 |
| Example 3 | ↑ | ↑ | 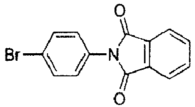 |
| Example 4 | ↑ | ↑ | 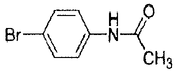 |
| Comparative Example 1 | ↑ | ↑ | 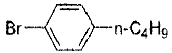 |

### [Table 2]

**Table 2**

| | Weight-average molecular weight | Yield [%] |
|---|---|---|
| Example 1 | 6,000 | 55 |
| Example 2 | 7,200 | 62 |
| Example 3 | 4,800 | 54 |
| Example 4 | 5,500 | 60 |
| Comparative Example 1 | 8,200 | 66 |

### [Evaluation of Organic EL Elements]

Each of the organic EL elements obtained in Examples 1 to 4 and Comparative Example 1 was transferred into the open atmosphere (room temperature: 25°C). A voltage was applied to the organic EL element using the ITO as the anode and the Al as the cathode, and the current efficiency at a luminance of 1,000 cd/m² was measured. Further, in order to evaluate the lifespan properties, the luminance was measured while a constant current was applied, and the time taken for the luminance to decrease by half from the initial luminance (3,000 cd/m²) was measured. Measurement of the luminance was performed using a BM-7 device manufactured by Topcon Corporation. The measurement results are shown in Table 3, relative to values of 100 for Comparative Example 1.

### [Table 3]

**Table 3**

| | Efficiency [relative value] | Lifespan [relative value] |
|---|---|---|
| Example 1 | 120 | 180 |
| Example 2 | 110 | 200 |
| Example 3 | 100 | 130 |
| Example 4 | 100 | 150 |
| Comparative Example 1 | 100 | 100 |

Using a polymer or oligomer (A) having an organic group (a) in the terminal structural unit improved the lifespan properties of the organic EL element. When the organic group (a) was a group having an ester linkage (Example 1 and Example 2), the improvement in the lifespan was particularly large.

### [Polymers Having an Organic Group (a) in a Non-Terminal Structural Unit]

### [Preparation of Organic EL Elements]

### (Example 5 and Comparative Example 2)

With the exception of using the monomers shown in Table 4, polymers were synthesized in the same manner as Example 1. The weight-average molecular weight and the yield of each polymer are shown in Table 5. Each polymer had a structural unit (1a) (derived from the monomer 2), a structural unit (2) having an organic group (a) (derived from the monomer 1) and a structural unit (1b) (derived from the monomer 3), and the relative proportions of those structural units were 41.7%, 25.0% and 33.3% respectively. Using the thus obtained polymers, organic EL elements were prepared in the same manner as Example 1.

### [Table 4]

**Table 4**

| | Monomer 1 | Monomer 2 | Monomer 3 |
|---|---|---|---|
| Example 5 | 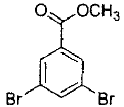 | 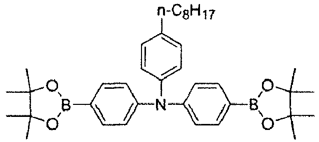 | 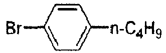 |
| Comparative Example 2 | 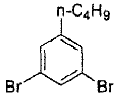 | ↑ | ↑ |

### [Table 5]

**Table 5**

| | Weight-average molecular weight | Yield [%] |
|---|---|---|
| Example 5 | 4,300 | 54 |
| Comparative Example 2 | 3,800 | 54 |

### [Evaluation of Organic EL Elements]

Each of the organic EL elements was evaluated for current efficiency and lifespan properties in the same manner as described in Example 1. The measurement results are shown in Table 6, relative to values of 100 for Comparative Example 2.

### [Table 6]

**Table 6**

| | Efficiency [relative value] | Lifespan [relative value] |
|---|---|---|
| Example 5 | 140 | 220 |
| Comparative Example 2 | 100 | 100 |

Using a polymer or oligomer (A) having an organic group (a) in a non-terminal structural unit improved the lifespan properties of the organic EL element.

### [Polymers Having an Organic Group (a) and a Polymerizable Substituent (b)]

### [Preparation of Organic EL Elements]

### (Examples 6 to 10 and Comparative Example 3)

### (Polymer Synthesis)

With the exception of using a monomer 1 (1.0 mmol), a monomer 2 (2.5 mmol), a monomer 3 (1.5 mmol) and a monomer 4 (0.5 mmol) shown in Table 7, polymers were synthesized in the same manner as Example 1. The weight-average molecular weight and the yield of each polymer are shown in Table 8. Each polymer had a structural unit (1a) (derived from the monomer 2), a structural unit (2b) (derived from the monomer 1), a structural unit (1c) having an organic group (a) (derived from the monomer 3) and a structural unit (1c) having a polymerizable substituent (b) (derived from the monomer 4), and the relative proportions of those structural units were 45.5%, 18.2%, 27.3% and 9.1% respectively.

### [Table 7]

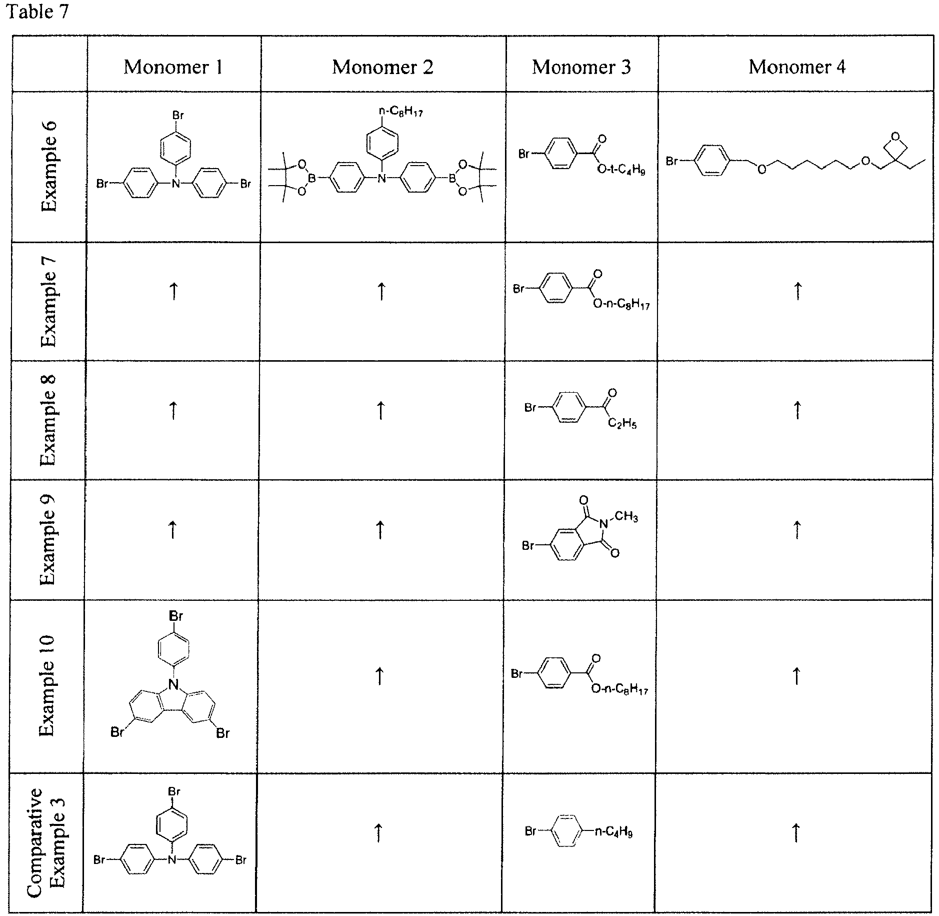

### [Table 8]

**Table 8**

| | Weight-average molecular weight | Yield [%] |
|---|---|---|
| Example 6 | 30,000 | 64 |
| Example 7 | 40,000 | 60 |
| Example 8 | 62,000 | 70 |
| Example 9 | 22,000 | 59 |
| Example 10 | 34,000 | 55 |
| Comparative Example 3 | 45,000 | 61 |

### (Preparation of Organic EL Elements)

The polymer (10 mg), the ionic compound 1 shown above (0.5 mg) and toluene (1,000 µL) were mixed together to prepare a composition 1. This composition 1 was spin-coated at a rotational rate of 3,000 min⁻¹ onto a glass substrate (length 22 mm × width 29 mm × thickness 0.7 mm) coated with an ITO pattern having a width of 1.6 mm, thus forming a thin film (organic layer). The solvent was removed from the thin film by heating on a hotplate at 180°C for 10 minutes, and the thin film (organic layer) was cured, thereby forming a hole injection and transport layer (thickness: 45 nm).

CBP (12.6 mg), Ir(piq)₃ (1.4 mg) and chlorobenzene (2 mL) were mixed together to prepare a composition 2. This composition 2 was spin-coated at a rotational rate of 3,000 min⁻¹ onto the hole injection and transport layer, and the solvent was then removed by heating on a hotplate at 80°C for 5 minutes, thus forming a light-emitting layer (thickness: 40 nm).

Each obtained glass substrate was transferred into a vacuum deposition apparatus, and BAlq (thickness: 10 nm), Alq₃ (thickness: 30 nm), LiF (thickness: 0.8 nm) and Al (thickness: 150 nm) were deposited in that order.

Following formation of the electrodes, the glass substrate was transferred into a dry nitrogen environment without exposure to the external atmosphere. A sealing glass formed from an alkali-free glass of thickness 0.7 mm provided with a concave portion having a depth of 0.4 mm and the glass substrate were bonded together using a photocurable epoxy resin, thereby sealing the substrate and completing preparation of an organic EL element having a multilayer structure.

### [Evaluation of Organic EL Elements]

Each of the organic EL elements was evaluated for current efficiency and lifespan properties in the same manner as described in Example 1. The measurement results are shown in Table 9, relative to values of 100 for Comparative Example 3. Further, the state of light emission from each organic EL element was inspected visually, and the emission uniformity was evaluated against the following criteria.
Good: no luminance irregularities (patches) and dark spots
Poor: luminance irregularities and dark spots

### [Table 9]

**Table 9**

| | Emission uniformity | Efficiency [relative value] | Lifespan [relative value] |
|---|---|---|---|
| Example 6 | Good | 100 | 4,000 |
| Example 7 | Good | 100 | 3,500 |
| Example 8 | Good | 110 | 2,800 |
| Example 9 | Good | 100 | 2,000 |
| Example 10 | Good | 110 | 3,200 |
| Comparative Example 3 | Poor | 100 | 100 |

Using a polymer or oligomer (A) having an organic group (a) and a polymerizable substituent (b) enabled an upper layer to be formed using a wet process, and also markedly improved the lifespan properties of the organic EL element. When the organic group (a) was a group having an ester linkage (Example 6, Example 7 and Example 10), the improvement in the lifespan was particularly large.

### [Polymer Having an Organic Group (a) and a Polymerizable Substituent (b), and Polymer Having an Organic Group (a) Containing a Polymerizable Group]

### [Preparation of Organic EL Elements]

### (Polymer Synthesis)

### (Example 11)

With the exception of using a monomer 1 (1.0 mmol), a monomer 2 (2.5 mmol), a monomer 3 (1.5 mmol) and a monomer 4 (0.5 mmol) shown in Table 10, a polymer was synthesized in the same manner as Example 6. The weight-average molecular weight and the yield of the polymer are shown in Table 11.

### (Example 12)

With the exception of using a monomer 1 (1.0 mmol), a monomer 2 (2.5 mmol), and a monomer 3 (2.0 mmol) shown in Table 10, a polymer was synthesized in the same manner as Example 1. The weight-average molecular weight and the yield of the polymer are shown in Table 11. The polymer had a structural unit (1a) (derived from the monomer 2), a structural unit (2b) (derived from the monomer 1) and a structural unit (1c) having a an organic group (a) containing a polymerizable group (derived from the monomer 3), and the relative proportions of those structural units were 45.5%, 18.2% and 36.4% respectively.

### (Comparative Example 4)

With the exception of using a monomer 1 (1.0 mmol), a monomer 2 (2.5 mmol), and a monomer 4 (2.0 mmol) shown in Table 10, a polymer was synthesized in the same manner as Example 1. The weight-average molecular weight and the yield of the polymer are shown in Table 11. The polymer had a structural unit (1a) (derived from the monomer 2), a structural unit (2b) (derived from the monomer 1) and a structural unit (1c) having a polymerizable substituent (b) (derived from the monomer 4), and the relative proportions of those structural units were 45.5%, 18.2% and 36.4% respectively.

### [Table 10]

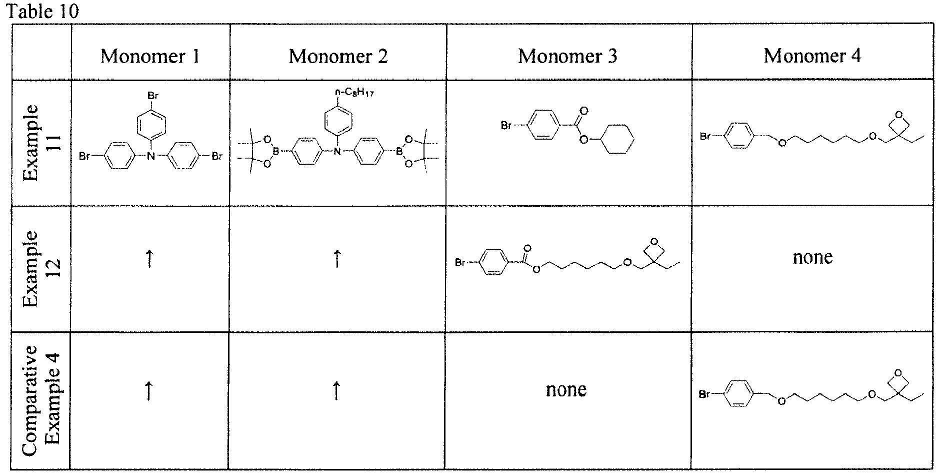

### [Table 11]

**Table 11**

| | Weight-average molecular weight | Yield [%] |
|---|---|---|
| Example 11 | 54,000 | 54 |
| Example 12 | 42,000 | 55 |
| Comparative Example 4 | 42,000 | 58 |

### (Preparation of Organic EL Elements)

With the exception of altering the heating conditions for the thin film to 220°C for 20 minutes, organic EL elements were prepared in the same manner as described in Example 6.

### [Evaluation of Organic EL Elements]

Each of the organic EL elements was evaluated for current efficiency and lifespan properties in the same manner as described in Example 1. The measurement results are shown in Table 12, relative to values of 100 for Comparative Example 3. Further, the state of light emission from each organic EL element was inspected visually, and the emission uniformity was evaluated against the following criteria.
Good: no luminance irregularities (patches) and dark spots
Poor: luminance irregularities and dark spots

### [Table 12]

**Table 12**

| | Emission uniformity | Efficiency [relative value] | Lifespan [relative value] |
|---|---|---|---|
| Example 11 | Good | 110 | 4,600 |
| Example 12 | Good | 100 | 3,800 |
| Comparative Example 4 | Good | 100 | 1,200 |
| Comparative Example 3 | Poor | 100 | 100 |

By using a polymer or oligomer (A) having an organic group (a) and a polymerizable substituent (b), or a polymer or oligomer (A) having an organic group (a) containing a polymerizable group, an upper layer was able to be formed using a wet process, and the lifespan properties of the organic EL element improved markedly.

In Example 11 and Example 12, a significant improvement in the lifespan was obtained compared with Comparative Example 4. It is surmised that the reason for this improvement is that by using the polymer or oligomer (A), the film-forming properties of the upper layer can be further improved, and that the film-forming properties and hole transport properties of the organic layer formed using the polymer or oligomer (A) are also improved.

Further, Example 11 and Example 12 confirmed that the polymer or oligomer (A) also exhibited excellent durability to heating at high temperature.

### [Evaluation of Curability (Residual Film Ratio)]

The low-temperature curability (residual film ratio) of the polymer or oligomer (A) was evaluated.

For each of the polymers prepared in Example 6, Example 11, Example 12 and Comparative Example 3, the polymer (5.0 mg) and the ionic compound 1 (0.15 mg) were dissolved in toluene (1,000 µL) to prepare an ink composition. The thus obtained ink composition was spin-coated at a rotational rate of 3,000 min⁻¹ onto a quartz plate having dimensions of 22 mm × 29 mm × thickness 1 mm, thus forming a thin film. Subsequently, the quartz plate was heated on a hotplate at 120°C or 180°C for 10 minutes to allow the polymerization reaction of the polymer to proceed. Following heating, the quartz plate was dipped in toluene (25°C) for one minute to wash the thin film. The absorbance (Abs) at the absorption maximum (λₘₐₓ) in the UV-vis spectrum was measured before and after washing of the thin film, and the residual film ratio was determined from the ratio between these two absorbance values. A spectrophotometer (U-3310, manufactured by Hitachi, Ltd.) was used for the absorbance measurements. The measurement results are shown in Table 13.

### [Table 13]

**Table 13**

| | Curing temperature (120°C) | Curing temperature (180°C) |
|---|---|---|
| | Residual film ratio (%) | Residual film ratio (%) |
| Example 6 | 42 | 99 |
| Example 11 | 38 | 99 |
| Example 12 | 94 | 99 |
| Comparative Example 3 | 28 | 99 |

Based on the results for Example 12, it is evident that the polymer or oligomer (A) having an organic group (a) containing a polymerizable group exhibits excellent curability at low temperature. By using a polymer or oligomer (A) having an organic group (a) containing a polymerizable group, a combination of good lifespan properties and low-temperature curability can be achieved.

The effects of the embodiments of the present invention have been illustrated above using a series of examples. Besides the polymers or oligomers (A) used in the examples, similar superior effects can be obtained using other polymers or oligomers (A) described above. In other words, the polymer or oligomer (A) according to an embodiment of the present invention has the organic group (a), and by using this polymer or oligomer (A), the lifespan properties of organic electronic elements can be improved. In particular, by using a polymer or oligomer (A) having the organic group (a) and the polymerizable substituent (b), an upper layer can be formed with good uniformity using a wet process, and as a result, the lifespan properties of the organic electronic element can be improved dramatically. Moreover, when the polymer or oligomer (A) has an organic group (a) containing a polymerizable group, favorable curability can be obtained across a broad temperature range, and therefore the productivity can also be improved.

The present application includes the following embodiments:
1. A polymer or oligomer (A),
   comprising a structural unit with hole transport properties, and
   also comprising at least one type of organic group selected from the group consisting of groups having an ester linkage, groups having a carbonyl linkage, groups having an amide linkage, and groups having an imide linkage.
2. The polymer or oligomer (A) according to item 1, wherein the structural unit with hole transport properties comprises at least one type of structural unit selected from the group consisting of units having an aromatic amine structure, units having a carbazole structure, and units having a thiophene structure.
3. The polymer or oligomer (A) according to item 1 or 2, further comprising a substituent having a polymerizable group.
4. The polymer or oligomer (A) according to any one of items 1 to 3, having a branched structure, and having three or more terminals.
5. The polymer or oligomer (A) according to any one of items 1 to 4, wherein the organic group comprises at least one type of organic group selected from the group consisting of organic groups (a1-1) to (a1-9): 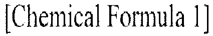 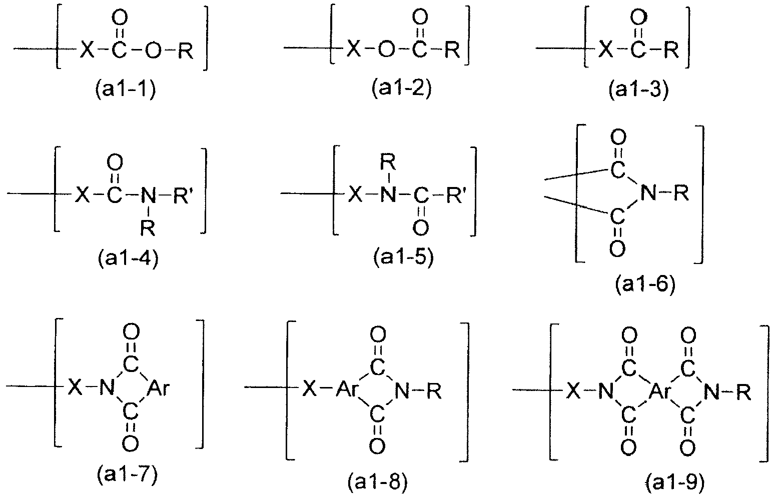
   wherein each R and R' independently represents a hydrogen atom, a linear, cyclic or branched alkyl group having a carbon number of 1 to 22, or an aryl group or heteroaryl group having a carbon number of 2 to 30,
   X represents a single bond, a linear, cyclic or branched alkylene group having a carbon number of 1 to 22, or an arylene group or heteroarylene group having a carbon number of 2 to 30, and
   Ar represents an arylene group or heteroarylene group having a carbon number of 2 to 30, an arene-triyl group or heteroarene-triyl group having a carbon number of 2 to 30, or an arene-tetrayl group or heteroarene-tetrayl group having a carbon number of 2 to 30.
6. The polymer or oligomer (A) according to any one of items 1 to 5, having a weight-average molecular weight of 1,000 to 1,000,000.
7. A composition, comprising the polymer or oligomer (A) according to any one of items 1 to 6, and a solvent (B).
8. The composition according to item 7, further comprising an ionic compound (C).
9. A hole transport material composition, comprising the composition according to item 7 or 8.
10. An ink composition, comprising the composition according to item 7 or 8.
11. An organic layer, formed using the composition according to item 7 or 8, the hole transport material composition according to item 9, or the ink composition according to item 10.
12. An organic electronic element, comprising at least two electrodes, and the organic layer according to item 11 positioned between the electrodes.
13. An organic electroluminescent element, comprising an anode, the organic layer according to item 11, a light-emitting layer and a cathode.
14. A display element, comprising the organic electroluminescent element according to item 13.
15. An illumination device, comprising the organic electroluminescent element according to item 13.
16. A display device, comprising the illumination device according to item 15, and a liquid crystal element as a display unit.
17. An organic photoelectric conversion element, comprising an anode, the organic layer according to item 11, a photoelectric conversion layer and a cathode.

### Reference Signs List

1: Anode
2: Organic layer (hole injection and transport layer)
3: Light-emitting layer
4: Cathode
5: Substrate
2': Organic layer (hole injection layer)
6: Hole transport layer
7: Electron transport layer
8: Electron injection layer

## Claims

1. A polymer or oligomer (A),
comprising a structural unit with hole transport properties, and
also comprising at least one type of organic group selected from the group consisting of groups having an ester linkage, groups having a carbonyl linkage, groups having an amide linkage, and groups having an imide linkage,
wherein the structural unit with hole transport properties comprises at least one type of structural unit selected from the group consisting of units having an aromatic amine structure, units having a carbazole structure, and units having a thiophene structure.

2. The polymer or oligomer (A) according to Claim 1, having a branched structure, and having three or more terminals.

3. The polymer or oligomer (A) according to Claim 1 or 2, wherein the organic group comprises at least one type of organic group selected from the group consisting of organic groups (a1-1) to (a1-9): 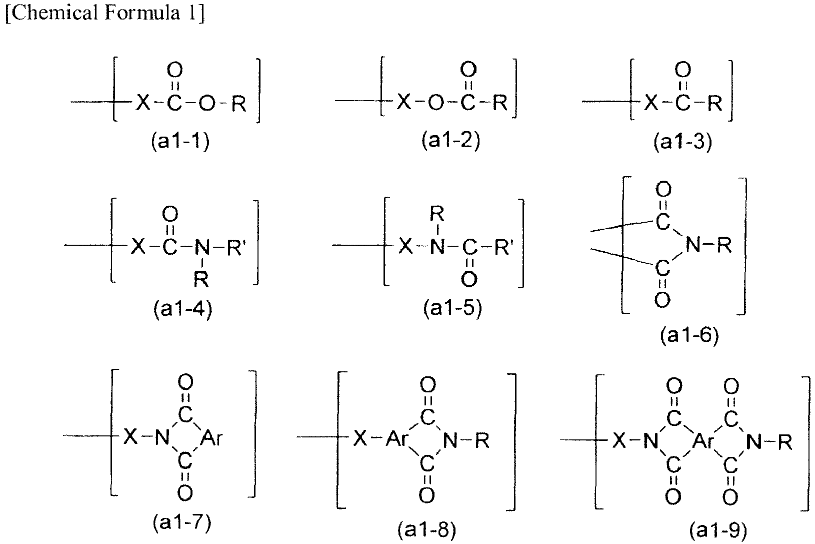
wherein each R and R' independently represents a hydrogen atom, a linear, cyclic or branched alkyl group having a carbon number of 1 to 22, or an aryl group or heteroaryl group having a carbon number of 2 to 30,
X represents a single bond, a linear, cyclic or branched alkylene group having a carbon number of 1 to 22, or an arylene group or heteroarylene group having a carbon number of 2 to 30, and
Ar represents an arylene group or heteroarylene group having a carbon number of 2 to 30, an arene-triyl group or heteroarene-triyl group having a carbon number of 2 to 30, or an arene-tetrayl group or heteroarene-tetrayl group having a carbon number of 2 to 30.

4. The polymer or oligomer (A) according to any one of Claims 1 to 3, having a weight-average molecular weight of 1,000 to 1,000,000.

5. A composition, comprising the polymer or oligomer (A) according to any one of Claims 1 to 4, and a solvent (B).

6. The composition according to Claim 5, further comprising an ionic compound (C).

7. A hole transport material composition, comprising the composition according to Claim 5 or 6.

8. An ink composition, comprising the composition according to Claim 5 or 6.

9. An organic layer, formed using the composition according to Claim 5 or 6, the hole transport material composition according to Claim 7, or the ink composition according to Claim 8.

10. An organic electronic element, comprising at least two electrodes, and the organic layer according to Claim 9 positioned between the electrodes.

11. An organic electroluminescent element, comprising an anode, the organic layer according to Claim 9, a light-emitting layer and a cathode.

12. A display element, comprising the organic electroluminescent element according to Claim 11.

13. An illumination device, comprising the organic electroluminescent element according to Claim 11.

14. A display device, comprising the illumination device according to Claim 13, and a liquid crystal element as a display unit.

15. An organic photoelectric conversion element, comprising an anode, the organic layer according to Claim 9, a photoelectric conversion layer and a cathode.
